(19) Europäisches Patentamt
European Patent Office
Office européen des brevets

(11) EP 3 933 906 A1

(12) EUROPEAN PATENT APPLICATION
published in accordance with Art. 153(4) EPC

(43) Date of publication:
**05.01.2022 Bulletin 2022/01**

(21) Application number: **20778462.0**

(22) Date of filing: **18.03.2020**

(51) Int Cl.:
***H01L 23/02*** *(2006.01)* ***C08F 2/50*** *(2006.01)*
***G03F 7/028*** *(2006.01)* ***G03F 7/031*** *(2006.01)*
***G03F 7/037*** *(2006.01)* ***G03F 7/09*** *(2006.01)*
***G03F 7/20*** *(2006.01)* ***H03H 3/08*** *(2006.01)*

(86) International application number:
**PCT/JP2020/011900**

(87) International publication number:
**WO 2020/196139 (01.10.2020 Gazette 2020/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **27.03.2019 JP 2019061079**

(71) Applicant: **Toray Industries, Inc.**
**Tokyo, 103-8666 (JP)**

(72) Inventors:
- **KATSURADA, Yuki**
  **Otsu-shi, Shiga 520-8558 (JP)**
- **KAWANO, Tomotaka**
  **Otsu-shi, Shiga 520-8558 (JP)**
- **KANAMORI, Daisuke**
  **Otsu-shi, Shiga 520-8558 (JP)**

(74) Representative: **Prüfer & Partner mbB**
**Patentanwälte · Rechtsanwälte**
**Sohnckestraße 12**
**81479 München (DE)**

# (54) PHOTOSENSITIVE RESIN COMPOSITION, PHOTOSENSITIVE RESIN SHEET, METHOD FOR PRODUCING HOLLOW STRUCTURE, AND ELECTRONIC COMPONENT

(57)

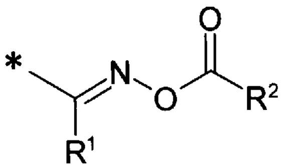

(1)

A photosensitive resin composition according to the present invention is a photosensitive resin composition comprising (a) an alkali-soluble polyimide, (b) an unsaturated bond-containing compound, (c) a thermally crosslinkable compound, (d-1) a photobleaching photopolymerization initiator having the structure represented by general formula (1), and (d-2) a photopolymerization initiator having the structure represented by general formula (1) and having a molar extinction coefficient at a wavelength of 405 nm of at least 1000 L/(mol · cm). (In general formula (1), $R^1$ represents a halogen atom, hydroxy group, carboxy group, nitro group, cyano group, $-NR^3R^4$, C1-20 monovalent hydrocarbon group, C1-20 acyl group, or C1-20 alkoxy group, and $R^3$ and $R^4$ each independently represent a hydrogen atom or C1-10 alkyl group, provided that at least a portion of the hydrogen atoms in the hydrocarbon group, acyl group, and alkoxy group may be substituted by a halogen atom, hydroxy group, carboxy group, nitro group, cyano group, or $-NR^3R^4$, and a hydrocarbon group present in the hydrocarbon group, in the acyl group, or in the alkoxy group may be interrupted by an ether bond, thioether bond, ester bond, thioester bond, amide bond, or urethane bond. $R^2$ represents a C1-5 alkyl group. The symbol * in the formula indicates bonding with a neighboring group via the * moiety.) The photosensitive resin composition according to the present invention is also a photosensitive resin composition comprising (a) an alkali-soluble polyimide, (b) an unsaturated bond-containing compound, (c) a thermally crosslinkable compound, and (d) at least two species of oxime ester-type photopolymerization initiators. The photosensitive resin composition according to the present invention enables a high-sensitivity, high-quality photographic patterning of the cap portion of a hollow structure. A photosensitive resin sheet that uses the photosensitive resin composition according to the present

EP 3 933 906 A1

## Description

### Technical Field

The present invention relates to a photosensitive resin composition, a photosensitive resin sheet, a method for producing hollow structures, and an electronic component.

### Background Art

In recent years, as devices such as cell phones and smartphones have become smaller, electronic components mounted thereon have become smaller and lower in height. For example, surface acoustic wave filters and micro-electromechanical systems (MEMS) are known as electronic components that require hollow structures. For electronic components requiring a hollow structure, it has been common to use a piezoelectric substrate or an inorganic material such as glass or silicon to form the hollow structure. Recently, however, a method of using a photosensitive resin for a hollow structure lid, which is easier to make smaller and lower profile, is becoming the mainstream. A photosensitive resin that is to be used as a lid is processed into a sheet (photosensitive resin sheet), and generally has a three-layer structure in which a photosensitive resin layer is sandwiched between a support film and a protective film. When using a photosensitive resin that is to be used as a lid, a protective film is peeled off, a photosensitive resin layer is attached to an area where a hollow structure is to be formed, and photolithography is performed, thereby forming a lid made of the photosensitive resin. Photosensitive resins can be processed thinner than inorganic materials such as glass and silicon, which is suitable for low-profile devices. Furthermore, since photosensitive resins can also allow fabrication of fine vias for electrode formation, photosensitive resins are also suitable for miniaturization, and commercialization of methods using photosensitive resins for hollow structure lids is in progress.

A photosensitive polyimide sheet containing a polyimide resin having excellent heat resistance, electrical properties, and mechanical properties has been previously proposed as a photosensitive resin sheet for use in a hollow structure lid (see, for example, Patent Literature 1). However, since polyimide resins absorb a large amount of light, the pattern shape tends to be reversed taper, resulting in insufficient embedding of metal used as a conductor, which tends to cause a conduction failure.

To address such a problem, a photosensitive polyimide sheet containing an alkali-soluble polyimide, an unsaturated bond-containing compound, a thermally crosslinkable compound, and a specified photopolymerization initiator has been proposed (see, for example, Patent Literature 2). Even when a polyimide resin was used, a pattern was able to be rectangular or forward tapered, and a hollow structure lid made of a polyimide resin having excellent heat resistance, electrical properties, and mechanical properties could be formed in a favorable shape.

However, when processing the photosensitive resin sheet described in Patent Literature 2, a high amount of exposure was required for sufficient light curing, resulting in an issue that required time for processing. When the amount of exposure was insufficient, problems such as a crack in a resin, falling of a hollow structure lid made of resin, and surface roughness of the resin occurred.

### Background Art

### Citation List

Patent Literature 1: JP 2010-10812 A
Patent Literature 2: WO2018/173840

### Summary of Invention

### Technical Problem

An object of the present invention is to provide a photosensitive resin composition by which a hollow structure lid portion can be patterned by photography with a high sensitivity and a favorable quality.

### Solution to Problem

In order to solve the above-described problems and achieve such an object, the photosensitive resin composition of the present invention includes the following configuration.

A photosensitive resin composition comprising an alkali-soluble polyimide (a), an unsaturated bond-containing compound (b), a thermally crosslinkable compound (c), a photopolymerization initiator (d-1) having the structure represented by the following general formula (1) and having a photobleaching property, and a photopolymerization initiator (d-2) having the structure represented by the following general formula (1) and having a molar absorption coefficient at a wavelength of 405 nm of 1,000 L/(mol·cm) or more

[Chem. 1]

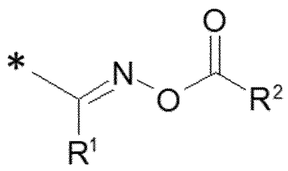

(1)

(In the general formula (1), $R^1$ represents a halogen atom, a hydroxyl group, a carboxyl group, a nitro group, a cyano group, $-NR^3R^4$, a monovalent hydrocarbon group having 1 to 20 carbon atoms, an acyl group having 1 to 20 carbon atoms, or an alkoxy group having 1 to 20 carbon atoms, and $R^3$ and $R^4$ each independently represent a hydrogen atom or an alkyl group having 1 to 10 carbon atoms. Note that at least one of hydrogen atoms of the hydrocarbon group, the acyl group, and the alkoxy group may be substituted by halogen atoms, hydroxyl groups, carboxyl groups, nitro groups, cyano groups, or $-NR^3R^4$, and the hydrocarbon groups in the hydrocarbon group, in the acyl group, and in the alkoxy group may be interrupted by an ether bond, a thioether bond, an ester bond, a thioester bond, an amide bond, or a urethane bond. $R^2$ represents an alkyl group having 1 to 5 carbon atoms. In the formula, * means that an adjacent group is bonded at *.)

Furthermore, the photosensitive resin composition of the present invention is a photosensitive resin composition composition comprising an alkali-soluble polyimide (a), an unsaturated bond-containing compound (b), a thermally crosslinkable compound (c), and two or more oxime ester photopolymerization initiators (d).

The photosensitive resin sheet of the present invention includes a support and a photosensitive resin layer formed on the support using the photosensitive resin composition of the present invention.

Furthermore, the method for producing a hollow structure of the present invention is the method comprising: a layering process (A) in which a photosensitive resin layer is formed by layering the above-described photosensitive resin sheet on a convex portion provided to form a hollow structure on a substrate in-such a manner to form a lid of the hollow structure; an exposure process (B) in which an exposed portion is photocured by irradiating an active ray to a predetermined portion of the photosensitive resin layer; a baking process (C) in which the exposed portions is promoted curing by heating the photosensitive resin layer; a peeling process (D) in which a support is peeled off; a development process (E) in which a portion of the photosensitive resin layer other than the exposed area is removed using a developer, if necessary; and a heat curing process (F) in which a resin cured product is formed by heat curing the exposed portion of the photosensitive resin layer.

Advantageous Effects of Invention

According to the present invention, a lid portion of a hollow structure can be patterned by photography with a high sensitivity and a favorable quality.

Brief Description of Drawings

Fig. 1 is a diagram illustrating a suitable method of processing one of the electronic components of the present invention, the surface acoustic wave filter (SAW filter), and one of the photosensitive resin sheets of the present invention.

Fig. 2 is a schematic diagram illustrating a crack in a photosensitive resin layer.

Fig. 3 is a schematic diagram illustrating deflection of a lid formed in a photosensitive resin layer.

Fig. 4 is a schematic diagram of a convex pattern in Examples and the Comparative Examples.

Fig. 5 is a schematic diagram of a pattern of a lid made of photosensitive resin layer in Examples and Comparative Examples.

Fig. 6 is a schematic diagram of a wafer on which a convex pattern is formed in Examples and Comparative Examples.

Description of Embodiments

Hereinafter, suitable embodiments of the photosensitive resin composition, the photosensitive resin sheet, the method for producing a hollow structure, and the electronic component of the present invention will be described in detail. However, the present invention is not limited to the following embodiments, and may be implemented in a variety of ways depending on the purpose and application.

< Photosensitive Resin Composition >

(Alkali-soluble Polyimide)

The photosensitive resin composition of the present invention contains an alkali-soluble polyimide (a). The alkali-soluble polyimide (a) is a ring-closed polyimide whose solubility in a 2.38% by mass aqueous solution of tetramethylammonium is 0.1 g/100 g or more at a temperature of 23°C.

The alkali-soluble polyimide (a) preferably includes at least one of a carboxyl group, a phenolic hydroxyl group, a sulfonic acid group, and a thiol group at the end of the main chain. This is because this configuration can improve the alkali solubility of the alkali-soluble polyimide (a). Considering the practicality for alkaline developers commonly used in the semiconductor industry, the alkali-soluble polyimide (a) preferably includes a phenolic hydroxyl group or a carboxyl group at the end of the main chain, and particularly preferably includes a phenolic hydroxyl group. Introduction of a carboxyl group, a phenolic hydroxyl group, a sulfonic acid group, or a thiol group to the end of the main chain can be done by using a terminal encapsulant having such a group. By encapsulating the end of the main chain, the number of repeating units of the alkali-soluble polyimide (a) becomes moderately small. Therefore, the processability of a fine pattern of a photosensitive resin composition containing the alkali-soluble polyimide (a) can be improved.

As an alkali-soluble polyimide (a) including at least one of a carboxyl group, a phenolic hydroxyl group, a sulfonic acid group, and a thiol group at the end of the main chain, for example, those having the structure represented by the following general formula (6) or the following general formula (7) are preferred.

[Chem. 2]

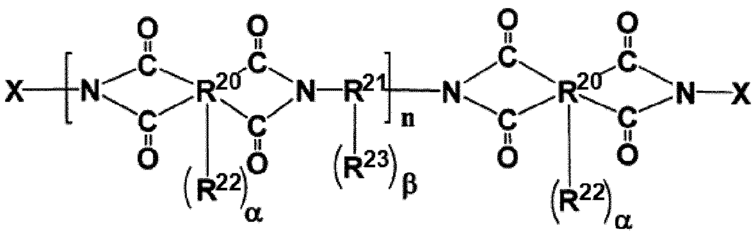

(6)

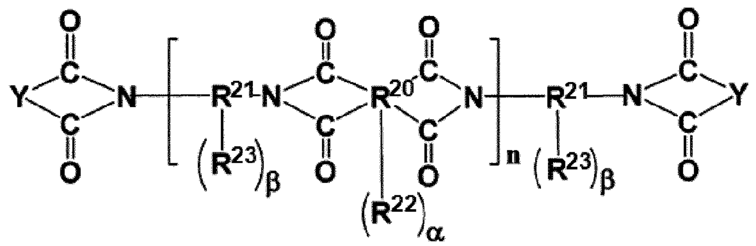

(7)

In general formulas (6) and (7), X represents a monovalent organic group including at least one of a carboxyl group, a phenolic hydroxyl group, a sulfonic acid group, and a thiol group. Y represents a divalent organic group including at least one of a carboxyl group, a phenolic hydroxyl group, a sulfonic acid group, and a thiol group. X and Y preferably include a phenolic hydroxyl group or a carboxyl group, and particularly preferably include a phenolic hydroxyl group.

$R^{20}$ represents a 4- to 14-valent organic group, and $R^{21}$ represents a 2- to 12-valent organic group. $R^{22}$ and $R^{23}$ each independently represent a carboxyl group, a phenolic hydroxyl group, a sulfonic acid group, or a thiol group. $R^{22}$ and $R^{23}$ are preferably phenolic hydroxyl groups or carboxyl groups, and particularly preferably phenolic hydroxyl

groups.

α and β each independently represent an integer in the range of from 0 to 10. In such α and β, α + β is preferably 1 or more. n represents the number of repeats of the structural unit of the polymer. The range of n is from 3 to 200. When n is 3 or more, the coating properties of the photosensitive resin composition can be improved. From the viewpoint of improving the coating properties, n is preferably 5 or more. On the other hand, when n is 200 or less, the solubility of the alkali-soluble polyimide (a) in an alkaline developer can be improved. From the viewpoint of improving the solubility, n is preferably less than 100. In each polymer chain, n is an integer, but n obtained by analysis from the alkali-soluble polyimide (a) is in some cases not an integer.

In the above-described general formulas (6) and (7), $R^{20}$ is a 4- to 14-valent organic group having a tetracarboxylic acid dianhydride-derived structure. Such an $R^{20}$ is preferably an organic group having 5 to 40 carbon atoms containing an aromatic group or a cyclic aliphatic group.

Examples of tetracarboxylic acid dianhydride include aromatic tetracarboxylic acid dianhydride and aliphatic tetracarboxylic acid dianhydride. Examples of the aromatic tetracarboxylic acid dianhydride include pyromellitic acid dianhydride, 3,3',4,4'-biphenyltetracarboxylic acid dianhydride, 2,3,3',4'-biphenyltetracarboxylic acid dianhydride, 2,2',3,3'-biphenyltetracarboxylic acid dianhydride, 3,3',4,4'-benzophenone tetracarboxylic acid dianhydride, 2,2',3,3'-benzophenone tetracarboxylic anhydride, 2,2-bis(3,4-dicarboxyphenyl)propane dianhydride, 2,2-bis(2,3-dicarboxyphenyl)propane dianhydride, 1,1-bis(3,4-dicarboxyphenyl)ethane dianhydride, 1,1-bis(2,3-dicarboxyphenyl)ethane dianhydride, bis(3,4-dicarboxyphenyl)methane dianhydride, bis(2,3-dicarboxyphenyl)methane dianhydride, bis(3,4-dicarboxyphenyl)sulfone dianhydride, bis(3,4-dicarboxyphenyl) ether dianhydride, 1,2,5,6-Naphthalenetetracarboxylic acid dianhydride, 9,9-bis(3,4-dicarboxyphenyl)fluoreneic anhydride, 9,9-bis{4-(3,4-dicarboxyphenoxy)phenyl}fluorenic acid dianhydride, 2,3,6,7-naphthalenetetracarboxylic anhydride, 2,3,5,6-pyridinetetracarboxylic acid dianhydride, 3,4,9,10-perylene tetracarboxylic acid dianhydride, 2,2-bis(3,4-dicarboxyphenyl)hexafluoropropane dianhydride. Examples of the aliphatic tetracarboxylic acid dianhydride include butane tetracarboxylic acid dianhydride and 1,2,3,4-cyclopentane tetracarboxylic acid dianhydride.

Examples of the tetracarboxylic acid dianhydride include an acid dianhydride having the structure shown below. In the present embodiment, two or more of the above-described aromatic tetracarboxylic acid dianhydrides, aliphatic tetracarboxylic acid dianhydrides, and acid dianhydrides having the structure shown below may be used as tetracarboxylic acid dianhydrides.

[Chem. 3]

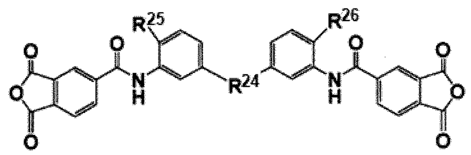

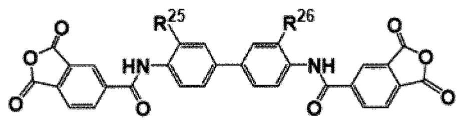

In the general formula representing an acid dianhydride of the above structure, $R^{24}$ represents an oxygen atom, $C(CF_3)_2$, $C(CH_3)_2$, or $SO_2$. $R^{25}$ and $R^{26}$ each independently represent a hydroxyl group or a carboxyl group.

In the above general formulas (6) and (7), $R^{21}$ is a 2- to 12-valent organic group having a diamine-derived structure. Such an $R^{21}$ is preferably an organic group having 5 to 40 carbon atoms containing an aromatic group or a cyclic aliphatic group.

Examples of the diamine include a hydroxyl group-containing diamine, a carboxyl group-containing diamine, a thiol group-containing diamine, an aromatic diamine, a compound in which at least some of the hydrogen atoms of these aromatic rings are substituted with an alkyl group or a halogen atom, and an aliphatic diamine.

Examples of the hydroxyl group-containing diamine include bis-(3-amino-4-hydroxyphenyl)hexafluoropropane, bis(3 -amino-4-hydroxyphenyl)sulfone, bis(3-amino-4-hydroxyphenyl)propane, bis(3 -amino-4-hydroxyphenyl)methylene, bis(3-amino-4-hydroxyphenyl)ether, bis(3-amino-4-hydroxy)biphenyl, bis(3-amino-4-hydroxyphenyl)fluorene. Examples of the carboxyl group-containing diamine include 2,2-bis[3-amino-4-carboxyphenyl] propane, 2,2-bis[4-amino-3-carboxyphenyl] propane, 2,2-bis[3-amino-4-carboxyphenyl] hexafluoropropane, 4,4'-diamino-2,2',5,5'-tetracarboxydiphenylmethane, 3,3'-diamino-4,4'-dicarboxydiphenyl ether, 4,4'-diamino-3,3'-dicarboxydiphenyl ether, 4,4'-diamino-2,2'-dicarboxydiphenyl ether, 4,4'-diamino-2,2',5,5'-tetracarboxydiphenyl ether, 3,3'-diamino-4,4'-dicarboxydiphenylsulfone, 4,4'-diamino-3,3'-dicarboxydiphenylsulfone, 4,4'-diamino-2,2'-dicarboxydiphenylsulfone, 4,4'-diamino-2,2',5,5'-tetracarboxydiphenylsulfone, 2,2-bis[4-(4-amino-3-carboxyphenoxy)phenyl]propane, 2,2-bis[4-(4-amino-3-carboxyphenoxy)phenyl]sulfone. Examples of the thiol group-containing diamine include dimercaptophenylenediamine.

Examples of the aromatic diamine include 3,3'-diaminodiphenyl ether, 3,4'-diaminodiphenyl ether, 4,4'-diaminodiphenyl ether, 3,3'-diaminodiphenylmethane, 3,4'-diaminodiphenylmethane, 4,4'-diaminodiphenylmethane, 3,3'-diaminodiphenylsulfone, 3,4'-diaminodiphenylsulfone, 4,4'-diaminodiphenylsulfone, 3,4'-diaminodiphenyl sulfide, 4,4'-diaminodiphenyl sulfide, 1,4-bis(4-aminophenoxy)benzene, 1,3-bis(4-aminophenoxy)benzene, 1,3-bis(3-aminophenoxy)benzene, 1,3-bis(3-aminophenoxy)benzene, benzidine, m-phenylenediamine, *p*-phenylenediamine, 1,5-naphthalenediamine, 2,6-naphthalenediamine, bis(4-aminophenoxyphenyl)sulfone, bis(3-aminophenoxyphenyl)sulfone, bis(4-aminophenoxy)biphenyl, bis{4-(4-aminophenoxy)phenyl}ether, 1,4-bis(4-aminophenoxy)benzene, 2,2'-dimethyl-4,4'-diaminobiphenyl, 2,2'-diethyl-4,4'-diaminobiphenyl, 3,3'-dimethyl-4,4'-diaminobiphenyl, 3,3'-diethyl-4,4'-diaminobiphenyl, 2,2',3,3'-tetramethyl-4,4'-diaminobiphenyl, 3,3',4,4'-tetramethyl-4,4'-diaminobiphenyl, 2,2'-di(trifluoromethyl)-4,4'-diaminobiphenyl, 9,9-bis(4-aminophenyl)fluorene. Examples of the aliphatic diamine include cyclohexyl diamine and methylenebiscyclohexylamine.

Examples of the diamine include a diamine having the structure shown below. In the present embodiment, as diamines, two or more of the above-described hydroxyl group-containing diamines, carboxyl group-containing diamines, thiol group-containing diamines, aromatic diamines, compounds in which at least some of the hydrogen atoms of these aromatic rings are substituted with alkyl groups or halogen atoms, aliphatic diamines, and diamines having the structures shown below may be used.

[Chem. 4]

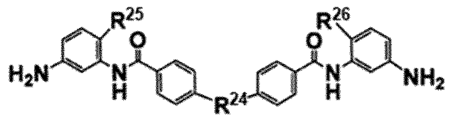

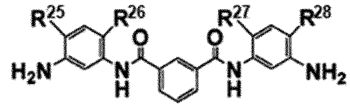

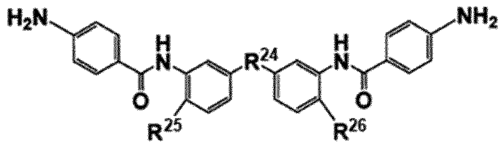

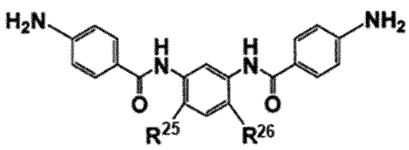

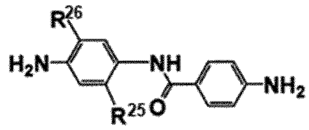

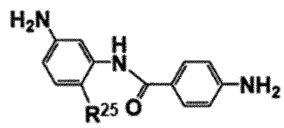

In the general formula representing a diamine having the above structure, the $R^{24}$ represents an oxygen atom, $C(CF_3)_2$, $C(CH_3)_2$, or $SO_2$. The $R^{25}$ to $R^{28}$ each independently represent a hydroxyl group or a carboxyl group.

Among the diamines described above, bis-(3-amino-4-hydroxyphenyl)hexafluoropropane, bis(3 -amino-4-hydroxyphenyl)sulfone, bis(3-amino-4-hydroxyphenyl)propane, bis(3 -amino-4-hydroxyphenyl)methylene, bis(3-amino-4-hydroxyphenyl)methylene, bis(3 -amino-4-hydroxyphenyl)ether, bis(3-amino-4-hydroxy)biphenyl, bis(3 -amino-4-hydroxyphenyl)fluorene, 2,2-bis [3 -amino-4-carboxyphenyl] propane, 2,2-bis[4-amino-3-carboxyphenyl]propane, 2,2-bis[3-amino-4-carboxyphenyl]propane, 2,2-bis[3-amino-4-carboxyphenyl] hexafluoropropane, 4,4'-diamino-2,2',5,5'-tetracarboxydiphenylmethane, 3,3'-diamino-4,4'-dicarboxydiphenyl ether, 4,4'-diamino-3,3'-dicarboxydiphenyl ether, 4,4'-diamino-2,2'-dicarboxydiphenyl ether, 4,4'-diamino-2,2',5,5'-tetracarboxydiphenyl ether, 3,3'-diamino-4,4'-dicarboxydiphenylsulfone, 4,4'-diamino-2,2'-dicarboxydiphenylsulfone, 4,4'-diamino-3,3'-dicarboxydiphenylsulfone, 4,4'-diamino-2,2'-dicarboxydiphenylsulfone, 4,4'-diamino-2,2',5,5'-tetracarboxydiphenylsulfone, 2,2-bis[4-(4-amino-3-carboxyphenoxy)phenyl]propane, 2,2-bis[4-(4-amino-3-carboxyphenoxy)phenyl]sulfone, 3,3'-diaminodiphenyl ether, 3,4'-diaminodiphenyl ether, 4,4'-diaminodiphenyl ether, 3,3'-diaminodiphenyl ether, 3,4'-diaminodiphenylmethane, 4,4'-diaminodiphenyl methane, 3,3'-diaminodiphenyl sulfone, 3,4'-diaminodiphenyl sulfone, 4,4'-diaminodiphenyl sulfone, 3,4'-diaminodiphenyl sulfide, 4,4'-diaminodiphenyl sulfide, *m*-phenylenediamine, p-phenylenediamine, 1,4-bis(4-aminophenoxy)benzene, 9,9-bis(4-aminophenyl)fluorene, and diamines having the structure shown below are preferred.

[Chem. 5]

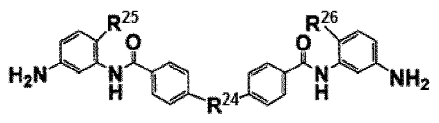
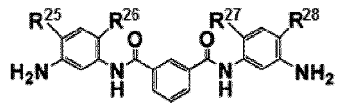
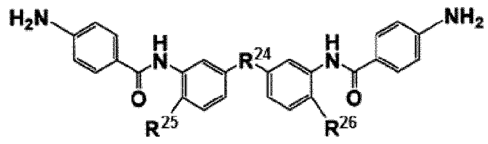
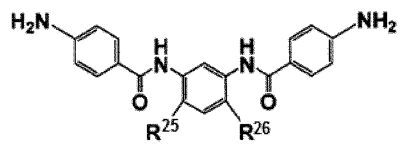

In the above-described general formulas (6) and (7), the $R^{22}$ and $R^{23}$ each independently represent a carboxyl group, a phenolic hydroxyl group, a sulfonic acid group, or a thiol group, as described above. By adjusting the amount of these $R^{22}$ and $R^{23}$ alkali-soluble groups, the dissolution rate of the alkali-soluble polyimide (a) in an aqueous alkaline solution is changed, and therefore a photosensitive resin composition having a desired dissolution rate can be obtained.

Furthermore, in the alkali-soluble polyimide (a) having the structure represented by the above-described general formulas (6) and (7), an aliphatic compound having a siloxane structure in the $R^{21}$ may be copolymerized to the extent that the heat resistance is not reduced. Copolymerization of an aliphatic compound having a siloxane structure can improve the transparency of the alkali-soluble polyimide (a), improve the adhesion between the alkali-soluble polyimide (a) and a substrate, and facilitate lamination when the alkali-soluble polyimide (a) is used in a photosensitive resin sheet. Examples of aliphatic compounds having a siloxane structure in the case of diamines include 1,3-bis(3-aminopropyl)tetramethyldisiloxane and 1,3-bis(p-amino-phenyl)octamethylpentasiloxane. These are preferably copolymerized at from 1 to 10 mol% of the total diamine in the alkali soluble polyimide (a).

In the general formula (6), X is derived from a primary monoamine, which is a terminal encapsulant. Examples of the primary monoamine that is a terminal encapsulant preferably include 5-amino-8-hydroxyquinoline, 1-hydroxy-7-aminonaphthalene, 1-hydroxy-6-aminonaphthalene, 1-hydroxy-5-aminonaphthalene, 1-hydroxy-4-aminonaphthalene, 2-hydroxy-7-aminonaphthalene, 2-hydroxy-6-aminonaphthalene, 2-hydroxy-5-aminonaphthalene, 1-carboxy-7-aminonaphthalene, 1-carboxy-6-aminonaphthalene, 1-carboxy-5-aminonaphthalene, 2-carboxy-7-aminonaphthalene, 2-carboxy-6-aminonaphthalene, 2-carboxy-5-aminonaphthalene, 2-aminobenzoic acid, 3-aminobenzoic acid, 4-aminobenzoic acid, 4-aminosalicylic acid, 5-aminosalicylic acid, 6-aminosalicylic acid, 2-aminobenzene sulfonic acid, 3-aminobenzene sulfonic acid, 4-aminobenzenesulfonic acid, 3-amino-4,6-dihydroxypyrimidine, 2-aminophenol, 3-aminophenol, 4-aminophenol, 2-aminothiophenol, 3-aminothiophenol, 4-aminothiophenol. Two or more of these primary amines may be used as such a terminal sealant.

In the general formula (7), Y is derived from a dicarboxylic anhydride that is a terminal encapsulant. Preferable examples of such a dicarboxylic anhydride that is a terminal encapsulant are 4-carboxyphthalic anhydride, 3-hydroxyphthalic anhydride, and *cis*-aconitic anhydride. Two or more of these dicarboxylic anhydrides may be used as such a terminal sealant.

The alkali-soluble polyimide (a) in the present invention may contain an alkali-soluble polyimide other than one having the structure represented by the general formula (6) or the general formula (7). In this case, an alkaline-soluble polyimide having the structure represented by the general formula (6) or the general formula (7) is preferably contained in 30% by mass or more of the total mass of the alkaline-soluble polyimide (a), and more preferably contained in 60% by mass or more. By containing 30% by mass or more of the alkali-soluble polyimide represented by the general formula (6) or (7), shrinkage of the alkali-soluble polyimide (a) during heat curing can be suppressed. Type of alkali-soluble polyimide having a structure other than the structure represented by the general formula (6) or the general formula (7) and the content thereof in the alkali-soluble polyimide (a) are preferably selected in such a manner that they do not impair the heat resistance and solubility in an alkaline developer of the alkali-soluble polyimide (a) obtained by a final heat treatment.

Alkali-soluble polyimide (a) can be synthesized using any method by replacing part of diamine with monoamine, which is a terminal encapsulant, or by replacing tetracarboxylic acid dianhydride with dicarboxylic anhydride, which is a terminal encapsulant. For example, the alkali-soluble polyimide (A) can be synthesized by a first method of reacting tetracarboxylic acid dianhydride with a diamine compound and a monoamine at a low temperature, a second method of reacting tetracarboxylic acid dianhydride, dicarboxylic anhydride, and a diamine compound at a low temperature, a third method in which a polyimide precursor is obtained by utilizing a method such as obtaining a diester from tetracarboxylic anhydride and an alcohol, and then reacting the diester with a diamine and a monoamine in the presence of a condensation agent, and then completely imidizing the obtained polyimide precursor using any imidization reaction method, or the like.

In the present invention, the imidization rate of the alkali-soluble polyimide (a) is preferably 90% or more from the viewpoint of further improving the electrical properties, mechanical properties, heat resistance, moisture resistance, and residual film rate of polyimide. Examples of the method of achieving the above-described range of the imidization ratio of the alkali-soluble polyimide (a) include a method of performing an imidization reaction at a reaction temperature of 160°C or higher and a reaction time of 2 hours or longer under a dry nitrogen stream.

The imidization rate of the alkali-soluble polyimide (a) in the present invention can be determined by the following method. First, the infrared absorption spectrum of the alkali-soluble polyimide (a) is measured, and the peak intensity PI near 1,377 $cm^{-1}$, which is the absorption peak originating from the imide structure, is determined. Next, the alkali-soluble polyimide (a) is heat-treated at 350°C for 1 hour, and then the infrared absorption spectrum is measured again to obtain the peak intensity P2 near 1,377 $cm^{-1}$. Using the obtained peak intensities PI and P2, the imidization rate of the alkali-soluble polyimide (a) can be determined based on the following formula.

$$\text{imidization rate [\%]} = (\text{peak intensity P1} / \text{peak intensity P2}) \times 100$$

The terminal encapsulant introduced into the alkali-soluble polyimide (a) can be detected by the following method. For example, the alkali-soluble polyimide (a) into which a terminal encapsulant has been introduced is dissolved in an acidic solution and decomposed into an amine component, which is a constituent unit of the polyimide, and a carboxylic anhydride component. Then, by analyzing these amine and carboxylic anhydride components by gas chromatography (GC) or NMR, the terminal encapsulant of the alkali-soluble polyimide (a) can be detected. The terminal encapsulant of the alkali-soluble polyimide (a) can also be detected by directly analyzing the alkali-soluble polyimide (a) into which the terminal encapsulant has been introduced using pyrolysis gas chromatography (PGC) or infrared spectrum and $^{13}$CNMR spectrum.

(Unsaturated Bond-containing Compound)

The photosensitive resin composition of the present invention contains an unsaturated bond-containing compound (b). The unsaturated bond-containing compound (b) is a compound containing an unsaturated bond. Examples of the unsaturated bond-containing group in the unsaturated bond-containing compound (b) include an unsaturated double bond-containing group such as a vinyl group, an allyl group, an acryloyl group, or a methacryloyl group, and an unsaturated triple bond-containing group such as a propagyl group. The unsaturated bond-containing compound (b) may contain two or more of these unsaturated bond-containing groups. Among them, a conjugated vinyl group, an acryloyl group, and a methacryloyl group are preferable in terms of polymerizability. From the viewpoint of suppressing a crack in a pattern caused by excessive crosslinking points resulting from a polymerization reaction, the number of unsaturated bonds in the unsaturated bond-containing compound (b) is preferably from 1 to 6.

The unsaturated bond-containing compound (b) preferably includes an isocyanate group or a blocked isocyanate group, and particularly preferably includes a blocked isocyanate group from the viewpoint of the stability. When an isocyanate group or a blocked isocyanate group reacts with an acidic group of the alkali-soluble polyimide (a), the alkali-soluble polyimide (a) and the unsaturated bond-containing compound (b) form a cross-linked structure. This increases the strength of a resin composition and facilitates retention of the shape of a lid when a photosensitive resin sheet is formed as a hollow structure lid.

Examples of unsaturated bond-containing compounds (b) that do not have isocyanate groups and blocked isocyanate groups include diethylene glycol diacrylate, triethylene glycol diacrylate, tetraethylene glycol diacrylate, diethylene glycol dimethacrylate, triethylene glycol dimethacrylate, tetraethylene glycol dimethacrylate, trimethylolpropane diacrylate, trimethylolpropane triacrylate, trimethylolpropane dimethacrylate, trimethylolpropane trimethacrylate, styrene, alpha-methylstyrene, 1,2-dihydronaphthalene, 1,2-dihydronaphthalene, 1,3-diisopropenylbenzene, 3-methylstyrene, 4-methylstyrene, 2-vinylnaphthalene, butyl acrylate, butyl methacrylate, isobutyl acrylate, hexyl acrylate, isooctyl acrylate, isobornyl acrylate, isobornyl methacrylate, cyclohexyl methacrylate, 1,3-butanediol diacrylate, 1,3-butanediol dimethacrylate, neopentyl glycol diacrylate, 1,4-butanediol diacrylate, 1,4-butanediol diacrylate, 1,4-butanediol dimethacrylate, 1,6-hexanediol diacrylate, 1,6-hexanediol dimethacrylate, 1,9-nonanediol dimethacrylate, 1,10-decanediol dimethacrylate, dimethylol-tricyclodecane diacrylate, pentaerythritol triacrylate, pentaerythritol tetraacrylate, pentaerythritol trimethacrylate, pentaerythritol tetramethacrylate, dipentaerythritol hexaacrylate, dipentaerythritol hexamethacrylate, 2-hydroxyethyl acrylate, 2-hydroxyethyl methacrylate, 1,3-diacryloyloxy-2-hydroxypropane, 1,3-dimethacryloyloxy-2-hydroxypropane, methylenebisacrylamide, *N*,*N*-dimethylacrylamide, *N*-methylolacrylamide, 2,2,6,6-tetramethylpiperidinyl methacrylate, 2,2,6,6-tetramethylpiperidinyl acrylate, *N*-methyl-2,2,6,6-tetramethylpiperidinyl methacrylate, *N*-methyl-2,2,6,6-tetramethylpiperidinyl acrylate, ethylene oxide-modified bisphenol A diacrylate, ethylene oxide-modified bisphenol A dimethacrylate, propylene oxide-modified bisphenol A diacrylate, propylene oxide-modified bisphenol A methacrylate, propoxylated ethoxylated bisphenol A diacrylate, propoxylated ethoxylated bisphenol A dimethacrylate, *N*-vinylpyrrolidone, and *N*-vinylcaprolactam. Examples of the unsaturated bond-containing compound (b) including an isocyanate group include 2-isocyanatoethyl acrylate, 2-isocyanatoethyl methacrylate, 1,1-(bisacryloyloxymethyl) ethyl isocyanate, and 2-(2-isocyanatoethoxy) ethyl methacrylate. Examples of the unsaturated bond-containing compound (b) including a blocked isocyanate group include 2-[*O*-(1'-methylpropylideneamino)carboxyamino]ethyl methacrylate and 2-[(3,5-dimethylpyrazolyl)carbonylamino]ethyl methacrylate. Two or more of types of these unsaturated bond-containing compounds (b) may be contained.

Among them, as the unsaturated bond-containing compound (b), 1,9-nonanediol dimethacrylate, 1,10-decanediol dimethacrylate, dimethylol-tricyclodecanediacrylate, isobornyl acrylate, isobornyl methacrylate, isobornyl methacrylate, pentaerythritol triacrylate, pentaerythritol tetraacrylate, pentaerythritol trimethacrylate, pentaerythritol tetramethacrylate, dipentaerythritol hexaacrylate, dipentaerythritol hexamethacrylate, methylenebisacrylamide, N,N-dimethylacrylamide, N-methylolacrylamide, 2,2,6,6-tetramethylpiperidinyl methacrylate, 2,2,6,6-tetramethylpiperidinyl acrylate, N-methyl-2,2,6,6-tetramethylpiperidinyl methacrylate, N-methyl-2,2,6,6-tetramethylpiperidinyl acrylate, ethylene oxide-modified bisphenol A diacrylate, ethylene oxide-modified bisphenol A dimethacrylate, propylene oxide-modified bisphenol A diacrylate, propylene oxide-modified bisphenol A methacrylate, propoxylated ethoxylated bisphenol A diacrylate, propoxylated ethoxylated bisphenol A dimethacrylate, N-vinylpyrrolidone, N-vinylcaprolactam, 2-isocyanatoethyl acrylate, 2-isocyanatoethyl methacrylate, 1,1-(bisacryloyloxymethyl)ethyl isocyanate, 2-(2-isocyanatoethoxy)ethyl methacrylate, methacrylic acid 2-[*O*-(1'-methylpropylideneamino)carboxyamino]ethyl, and 2-[(3,5-dimethylpyrazolyl)carbonylamino]ethyl methacrylate are preferable. Among them, dipentaerythritol hexaacrylate, dipentaerythritol hexamethacrylate, ethylene oxide-modified bisphenol A diacrylate, ethylene oxide-modified bisphenol A dimethacrylate, propylene oxide-modified bisphenol A diacrylate, propylene oxide-modified bisphenol A methacrylate, 2-isocyanatoethyl acrylate, 2-isocyanatoethyl methacrylate, 1,1-(bis-acryloyloxymethyl)ethyl isocyanate, 2-(2-isocyanatoethoxy)ethyl methacrylate, 2-[O-(1'-methylpropylideneamino)carboxyamino]ethyl methacrylate, or 2-[(3,5-dimethylpyrazolyl)carbonylamino]ethyl methacrylate is further preferable.

From the viewpoint of improving the residual film rate after development, the content of unsaturated bond-containing compound (b) in the photosensitive resin composition of the present invention based on 100 parts by mass of the alkali-soluble polyimide (a) is preferably 40 parts by mass or more, and more preferably 50 parts by mass or more. On the other hand, from the viewpoint of improving the heat resistance of the cured film, the content of the unsaturated bond-containing compound (b) based on 100 parts by mass of the alkali-soluble polyimide (a) is preferably 150 parts by mass or less, and more preferably 100 parts by mass or less.

From the viewpoint of facilitating retention of the shape of a lid of a hollow structure, the content of the unsaturated bond-containing compound (b) including an isocyanate group or a blocked isocyanate group in the photosensitive resin composition of the present invention based on 100 parts by mass of the unsaturated bond-containing compound (b) is preferably 5 parts by mass or more, more preferably 10 parts by mass or more, and still more preferably 20 parts by mass or more. On the other hand, from the viewpoint of sufficiently achieving the alkaline solubility of the alkali-soluble polyimide (a), the content of the unsaturated bond-containing compound (b) including an isocyanate group or a blocked isocyanate group based on 100 parts by mass of the unsaturated bond-containing compound (b) is preferably 80 parts by mass or less, more preferably 50 parts by mass or less, and still more preferably 30 parts by mass or less.

(Thermally Crosslinkable Compound)

The photosensitive resin composition of the present invention contains a thermally crosslinkable compound (c). The thermally crosslinkable compound (c) is a compound having thermally crosslinking properties. As the thermally crosslinkable compound (c), for example, a compound including at least one of an alkoxymethyl group, a methylol group, and an epoxy group is preferable, and a compound including at least two of an alkoxymethyl group, a methylol group, and an epoxy group is more preferable. By including at least two of these groups, the thermally crosslinkable compound (c) forms a crosslink structure by a reaction between the alkali-soluble polyimide (a) and the thermally crosslinkable compound (c), or by a reaction between the thermally crosslinkable compounds (c). As a result, the mechanical properties and chemical resistance of a cured film after heat treatment of the thermally crosslinkable compound (c) can be improved, and the shape of a hollow structure lid is more easily retained.

Among the thermally cross-linkable compounds (c), examples of a compound including an alkoxymethyl group or a methylol group include 46DMOC and 46DMOEP (all trade names, manufactured by Asahi Organic Chemicals Industry Co., Ltd.), DML-PC, DML-PEP, DML-OC, DML-OEP, DML-34X, DML-PTBP, DML-PCHP, DML-OCHP, DML-PFP, DML-PSBP, DML-POP, DML-MBOC, DML-MBPC, DML-MTrisPC, DML-BisOC-Z, DML-BisOCHP-Z, DML-BPC, DMLBisOC-P, DMOM-PC, DMOM-PTBP, DMOM-MBPC, TriML-P, TriML-35XL, TML-HQ, TML-BP, TML-pp-BPF, TML-BPE, TML-BPA, TML-BPAF, TML-BPAP, TMOM-BP, TMOM-BPE, TMOM-BPA, TMOM-BPAF, TMOM-BPAP, HML-TPPHBA, HML-TPHAP, HMOM-TPPHBA, and HMOM-TPHAP (all trade names, manufactured by Honshu Chemical Industry Co., Ltd.), and "NIKALAC" (registered trademark) MX-290, "NIKALAC" MX-280, "NIKALAC" MX-270, "NIKALAC" MX-279, "NIKALAC" MW-100LM, and "NIKALAC" MX-750LM (all trade names, manufactured by SANWA Chemical

Co., Ltd.). Two or more types of these may be contained in the thermally crosslinkable compound (c).

Examples of thermally crosslinkable compounds (c) including an epoxy group include a bisphenol A epoxy resin, a bisphenol F epoxy resin, propylene glycol diglycidyl ether, polypropylene glycol diglycidyl ether, polymethyl (glycidiroxypropyl), and an epoxy group-containing silicone. Specific examples thereof include "EPICLON" (registered trademark )850-S, "EPICLON" HP-4032, "EPICLON" HP-7200, "EPICLON" HP-820, "EPICLON" HP-4700, "EPICLON" EXA-4710, "EPICLON" HP-4770, "EPICLON" EXA-859CRP, "EPICLON" EXA-1514, "EPICLON" EXA-4880, "EPICLON" EXA-4850-150, "EPICLON" EXA-4850-1000, "EPICLON" EXA-4816, and "EPICLON" EXA-4822 (all trade names, manufactured by DIC CORPORATION), "RIKARESIN" (registered trademark) BEO-60E, "RIKARESIN" BPO-20E, "RIKARESIN" HBE-100, and "RIKARESIN" DME-100 (all trade names, manufactured by New Japan Chemical Co., Ltd.), EP-4003S and EP-4000S (all trade names, manufactured by ADEKA CORPORATION), PG-100, CG-500, and EG-200 (all trade names, manufactured by Osaka Gas Chemicals Co., Ltd.), NC-3000 and NC-6000 (all trade names, manufactured by Nippon Kayaku Co., Ltd.), "EPOX" (registered trademark) -MK R508, "EPOX" -MK R540, "EPOX" -MK R710, "EPOX" -MK R1710, VG3101L, and VG3101M80 (all trade names, manufactured by Printec Corporation), and "CELLOXIDE" (registered trademark) 2021P, "CELLOXIDE" 2081, "CELLOXIDE" 2083, and "CELLOXIDE" 2085 (all trade names, manufactured by Daicel Corporation). Two or more of these thermally cross-linkable compounds (c) may be contained.

From the viewpoint of improving the heat resistance of a cured film, the content of the thermo-crosslinkable compound (c) in the photosensitive resin composition of the present invention based on 100 parts by mass of the alkali-soluble polyimide (a) is preferably 1 part by mass or more, and more preferably 5 parts by mass or more. On the other hand, from the viewpoint of improving the residual film rate after development, the content of the thermally crosslinkable compound (c) based on 100 parts by mass of the alkali-soluble polyimide (a) is preferably 70 parts by mass or less, and more preferably 50 parts by mass or less.

(Photopolymerization Initiator)

The photosensitive resin composition of the present invention contains an alkali-soluble polyimide (a), an unsaturated bond-containing compound (b), a thermally crosslinking agent (c), a photopolymerization initiator (d-1), and a photopolymerization initiator (d-2).

The photopolymerization initiator (d-1) is a photopolymerization initiator having a photobleaching property. The photobleaching property refers to a property in which decomposition progresses by exposure, resulting in fading and reduced absorption of light. Such a photopolymerization initiator improves transparency upon exposure to light, allowing light to penetrate to the interior.

The photopolymerization initiator (d-2) is a photopolymerization initiator whose molar absorption coefficient at a wavelength of 405 nm is 1,000 L/(mol-cm) or higher. The molar absorption coefficient is a constant that indicates the ability of a substance to absorb light, and the higher the value, the higher the ability to absorb light.

The molar absorption coefficient ε405 of a photopolymerization initiator at a wavelength of 405 nm can be measured by the following method. First, a photopolymerization initiator is dissolved in a soluble solvent as in evaluation of a photobleaching property, and the absorbance $Abs_{405}$ at a wavelength of 405 nm is measured by a spectrophotometer. Then, by substituting the value into the Lambert-Beer's equation below, the molar absorption coefficient $\varepsilon_{405}$ at a wavelength of 405 nm can be calculated.

$$\varepsilon_{405} = Abs_{405} / (C \cdot l)$$

C is the concentration of a solution and 1 is the optical path length of a measurement sample.

The photopolymerization initiator (d-1) and the photopolymerization initiator (d-2) have the structure represented by the following general formula (1).

[Chem. 6]

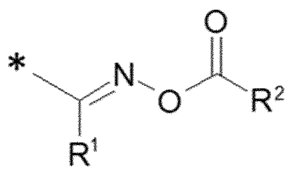

(1)

In the general formula (1), $R^1$ represents a halogen atom, a hydroxyl group, a carboxyl group, a nitro group, a

cyano group, $-NR^3R^4$, a monovalent hydrocarbon group having 1 to 20 carbon atoms, an acyl group having 1 to 20 carbon atoms, or an alkoxy group having 1 to 20 carbon atoms, and $R^3$ and $R^4$ each independently represent a hydrogen atom or an alkyl group having 1 to 10 carbon atoms. Note that at least one of hydrogen atom of the hydrocarbon group, the acyl group, and the alkoxy group may be substituted by halogen atoms, hydroxyl groups, carboxyl groups, nitro groups, cyano groups, or $-NR^3R^4$, and the hydrocarbon groups in the hydrocarbon group, in the acyl group, and in the alkoxy group may be interrupted by an ether bond, a thioether bond, an ester bond, a thioester bond, an amide bond, or a urethane bond. $R^2$ represents an alkyl group having 1 to 5 carbon atoms. In the formula, * means that an adjacent group is bonded at *. The $R^2$ is preferably a methyl group.

By containing the alkali-soluble polyimide (a), the unsaturated bond-containing compound (b), the photopolymerization initiator (d-1), and the photopolymerization initiator (d-2), a negative type pattern that is easily dissolved in an alkaline developer before exposure but becomes insoluble in an alkaline developer after exposure can be formed. Since the photopolymerization initiator (d-1) has a photobleaching property, the photosensitive resin composition of the present invention exhibits high internal curability, facilitating the pattern shape to be rectangular or forward tapered even when used as a hollow structure lid.

The photobleaching property of a photopolymerization initiator can be examined by the following method. First, the photopolymerization initiator is dissolved in a soluble solvent, and the absorbance is measured by a spectrophotometer. The concentration of the solution is adjusted to be within the measurement range of the spectrophotometer. As a solvent, methanol, ethanol, chloroform, acetonitrile, propylene glycol monomethyl ether acetate, ethyl lactate, or any other solvent that does not interfere with the measurement of the absorbance of the photopolymerization initiator can be used. Next, the solution of the photopolymerization initiator is fully exposed to light of a wavelength at which the photopolymerization initiator absorbs light and reacts, and the absorbance is measured again. The absorbance Abs (before exposure) before exposure at which the absorbance is 20% in the longer wavelength region than the maximum absorption wavelength when the absorbance at the maximum absorption wavelength before exposure is set to 100% is obtained. When there are two or more maximum absorption wavelengths, the maximum absorption wavelength in the long wavelength region is used. Next, the absorbance Abs (after exposure) after exposure at the same wavelength as Abs (before exposure) is obtained, and Abs (before exposure) and Abs (after exposure) are compared. Abs (before exposure) > Abs (after exposure) indicates that the photopolymerization initiator has a photobleaching property.

Since the photopolymerization initiator (d-1) having a photobleaching property has a small molar absorption coefficient, the photosensitive resin composition has low sensitivity when used singly, and when processed as a hollow structure lid at a low exposure level, failures such as cracks in the resin, depression of the hollow structure lid that is the resin, and surface roughness of the resin occur.

The photopolymerization initiator (d-2) has high surface curing properties due to its large molar absorption coefficient, which can improve the sensitivity of a photosensitive resin composition, and improve problems such as a crack in a resin during low exposure processing, depression of a hollow structure lid that is a resin, and surface roughness of a resin. The photopolymerization initiator (d-2) often does not exhibit a photobleaching property and has poor internal curability, and therefore the pattern shape tends to be reversed taper. From the above, when the photosensitive resin composition of the present invention contains the photopolymerization initiator (d-1) and the photopolymerization initiator (d-2), the balance between the surface curing properties and the internal curing properties becomes favorable, and a lid portion of a hollow structure can be patterned by photography with a high sensitivity and a favorable quality.

Furthermore, the photosensitive resin composition of the present invention is a photosensitive resin composition comprising an alkali-soluble polyimide (a), an unsaturated bond-containing compound (b), a thermally crosslinkable compound (c), and two or more types of oxime ester photopolymerization initiators (d).

The photosensitive resin composition of the present invention is preferably a photosensitive resin composition in which the oxime ester photopolymerization initiator (d) has the structure represented by the following general formula (2) and comprises at least one or more types of photopolymerization initiators (d-1) having a photobleaching property.

[Chem. 7]

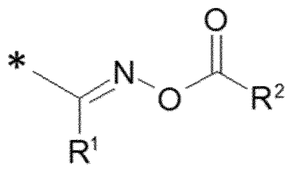

(2)

In the general formula (2), $R^1$ represents a halogen atom, a hydroxyl group, a carboxyl group, a nitro group, a cyano group, $-NR^3R^4$, a monovalent hydrocarbon group having 1 to 20 carbon atoms, an acyl group having 1 to 20 carbon atoms, or an alkoxy group having 1 to 20 carbon atoms, and $R^3$ and $R^4$ each independently represent a hydrogen

atom or an alkyl group having 1 to 10 carbon atoms. Note that at least one of the hydrogen atoms in the hydrocarbon group, the acyl group, and the alkoxy group may be substituted by a halogen atom, a hydroxyl group, a carboxyl group, a nitro group, a cyano group, or $-NR^3R^4$, and the hydrocarbon groups in the hydrocarbon group, the acyl group, and the alkoxy group may be interrupted by an ether bond, a thioether bond, an ester bond, a thioester bond, an amide bond, or a urethane bond. $R^2$ represents an alkyl group having 1 to 5 carbon atoms. * in the formula means that an adjacent group is bonded at *. $R^2$ is preferably a methyl group.

The photosensitive resin composition of the present invention is preferably a photosensitive resin composition in which the oxime ester photopolymerization initiator (d) comprises at least one type of the photopolymerization initiator (d-2) having a structure represented by the following general formula (3) and a molar absorption coefficient at a wavelength of 405 nm of 1,000 L/(mol·cm) or more.

[Chem. 8]

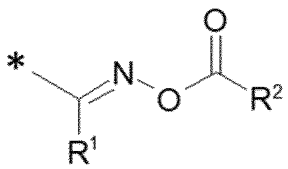

(3)

In general formula (3), $R^1$ represents a halogen atom, a hydroxyl group, a carboxyl group, a nitro group, a cyano group, $-NR^3R^4$, a monovalent hydrocarbon group having 1 to 20 carbon atoms, an acyl group having 1 to 20 carbon atoms, or an alkoxy group having 1 to 20 carbon atoms, and $R^3$ and $R^4$ each independently represent a hydrogen atom or an alkyl group having 1 to 10 carbon atoms. Note that at least one of the hydrogen atoms in the hydrocarbon group, the acyl group, and the alkoxy group may be substituted by halogen atoms, hydroxyl groups, carboxyl groups, nitro groups, cyano groups, or $-NR^3R^4$, and the hydrocarbon groups in the hydrocarbon group, the acyl group, and the alkoxy group may be interrupted by an ether bond, a thioether bond, an ester bond, a thioester bond, an amide bond, or a urethane bond. $R^2$ represents an alkyl group having 1 to 5 carbon atoms. * in the formula means that an adjacent group is bonded at *. $R^2$ is preferably a methyl group.

The photopolymerization initiator (d-1) is preferably a structure represented by the following general formula (4).

[Chem. 9]

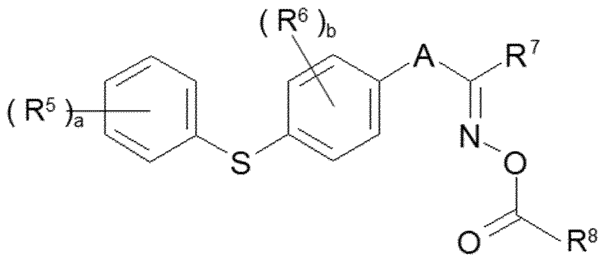

(4)

In the general formula (4), $R^5$ to $R^7$ each independently represent a halogen atom, a hydroxyl group, a carboxyl group, a nitro group, a cyano group, $-NR^9R^{10}$, a monovalent hydrocarbon group having 1 to 20 carbon atoms, an acyl group having 1 to 20 carbon atoms, or an alkoxy group having 1 to 20 carbon atoms, and $R^9$ and $R^{10}$ each independently represent a hydrogen atom or an alkyl group having 1 to 10 carbon atoms. Note that at least one of the hydrogen atoms in the hydrocarbon group, the acyl group, and the alkoxy group may be substituted by a halogen atom, a hydroxyl group, a carboxyl group, a nitro group, a cyano group, or $-NR^9R^{10}$, and the hydrocarbon groups in the hydrocarbon group, the acyl group, and the alkoxy group may be interrupted by an ether bond, a thioether bond, an ester bond, a thioester bond, an amide bond, or a urethane bond. $R^8$ represents an alkyl group having 1 to 5 carbon atoms. Among them, $R^5$ is preferably an acyl group having 1 to 20 carbon atoms or an alkoxy group having 1 to 20 carbon atoms, more preferably an acyl group having 1 to 10 carbon atoms or an alkoxy group having 1 to 10 carbon atoms, and still more preferably an acyl group having 1 to 10 carbon atoms. The acyl group preferably includes at least one of an aromatic ring and an ether bond. The alkoxy group is preferably one in which some of the hydrogen atoms are substituted with hydroxyl groups. $R^7$ is preferably a monovalent hydrocarbon group having 1 to 20 carbon atoms, and is more preferably a monovalent hydrocarbon group having 1 to 10 carbon atoms. $R^8$ is preferably a methyl group.

In general formula (2), a is an integer of 0 to 5 and b is an integer of 0 to 4. A represents CO or a direct bond.

a is preferably "1", b is preferably "0", and A is preferably a direct bond. Examples of the photopolymerization initiator (d-1) include some compounds described in WO 2012/002028, and some compounds described in WO 2015/036910.

The photopolymerization initiator (d-2) is preferably a structure represented by the following general formula (5).

[Chem. 10]

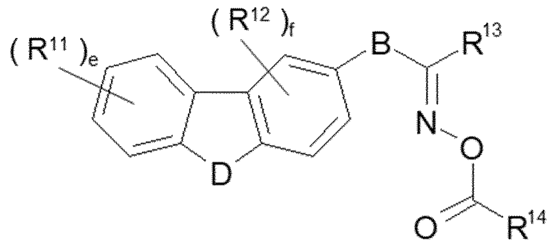

(5)

In the general formula (5), $R^{11}$ to $R^{13}$ each independently represent a halogen atom, a hydroxyl group, a carboxyl group, a nitro group, a cyano group, $-NR^{15}R^{16}$, a monovalent hydrocarbon group having 1 to 20 carbon atoms, an acyl group having 1 to 20 carbon atoms, or an alkoxy group having 1 to 20 carbon atoms, and $R^{15}$ and $R^{16}$ each independently represent a hydrogen atom or an alkyl group having 1 to 10 carbon atoms. Note that at least one of the hydrogen atoms in the hydrocarbon group, the acyl group, and the alkoxy group may be substituted by halogen atoms, hydroxyl groups, carboxyl groups, nitro groups, cyano groups, or $-NR^{15}R^{16}$, and the hydrocarbon groups in the hydrocarbon group, the acyl group, and the alkoxy group may be interrupted by an ether bond, a thioether bond, an ester bond, a thioester bond, an amide bond, or a urethane bond. $R^{14}$ represents an alkyl group having 1 to 5 carbon atoms. Among them, $R^{11}$ is preferably a nitro group. $R^{13}$ is preferably at least one of an aromatic ring and an ether bond. $R^{14}$ is preferably a methyl group.

In general formula (5), e represents an integer of 0 to 4 and f represents an integer of 0 to 3. B represents CO or a direct bond. D represents $-N(R^{17})-$ or$-C(R^{18})(R^{19})-$. $R^{17}$ to $R^{19}$ each independently represent a hydrogen atom, or a monovalent hydrocarbon group substituent having 1 to 10 carbon atoms. e is preferably "1", and f is preferably "0". B is preferably a direct bond. D is preferably $-N(R^{17})-$, and $R^{17}$ is further preferably an alkyl chain having 5 or less carbon atoms.

From the viewpoint of improving the surface curing properties of the photosensitive resin composition, the molar absorption coefficient of the photopolymerization initiator (d-2) at a wavelength of 405 nm is preferably 1,000 L/(mol·cm) or more, more preferably 2,000 L/(mol·cm) or more, and still more preferably 3,000 L/(mol·cm) or more.

Examples of the photopolymerization initiator (d-2) include some compounds described in WO 2008/078678.

From the viewpoint of effectively promoting photocuring reaction of the unsaturated bond-containing compound (b) during exposure, the total amount of the photopolymerization initiator (d-1) and the photopolymerization initiator (d-2) in the photosensitive resin composition of the present invention based on 100 parts by mass of the alkali-soluble polyimide (a) is preferably 1 part by mass or more, more preferably 3 parts by mass or more, still more preferably 4 parts by mass or more, and most preferably 7 parts by mass or more.

From the viewpoint of further improving the transmittance of a photosensitive resin composition and suppressing excessive polymerization reaction, the total amount of the photopolymerization initiator (d-1) and photopolymerization initiator (d-2) based on 100 parts by mass of the alkali-soluble polyimide (a) is preferably 30 parts by mass or less, more preferably 20 parts by mass or less, still more preferably 15 parts by mass or less, and most preferably 10 parts by mass or less.

From the viewpoint of improving the sensitivity of a photosensitive resin composition, the content of the photopolymerization initiator (d-2) in the photosensitive resin composition of the present invention based on 100 parts by mass of the photopolymerization initiator (d-1) is preferably 5 parts by mass or more, more preferably 10 parts by mass or more, and still more preferably 20 parts by mass or more. On the other hand, from the viewpoint of improving resolution and making it easier to process the pattern shape into a forward taper or rectangle, the content of the photopolymerization initiator (d-2) based on 100 parts by mass of the photopolymerization initiator (d-1) is preferably 50 parts by mass or less, more preferably 40 parts by mass or less, and still more preferably 30 parts by mass or less.

The content of the photopolymerization initiator (d-2) in the photosensitive resin composition of the present invention based on 100 parts by mass of the photopolymerization initiator (d-1) is more preferably 5 to 50 parts by mass, and still more preferably 10 to 30 parts by mass.

(Sensitizer)

The photosensitive resin composition of the present invention can further comprise a sensitizer (e). By using

the sensitizer (e), the photopolymerization initiator (d-1) and the photopolymerization initiator (d-2) are efficiently sensitized, and the sensitivity is further improved.

Among the sensitizers (e), a thioxanthone compound is preferred, and thioxanthone, 2-methylthioxanthone, 2-ethylthioxanthone, 2-propylthioxanthone, 4-methylthioxanthone, 4-ethylthioxanthone, 4-propylthioxanthone, 2-methyl-4-ethylthioxanthone, 2-ethyl-4-propylthioxanthone, 2-ethyl-4-methylthioxanthone, 2-ethyl-4-propylthioxanthone, 2-propyl-4-methylthioxanthone, 2-propyl-4-ethylthioxanthone, 2,4-dimethylthioxanthone, 2,4-diethylthioxanthone, 2,4-dipropylthioxanthone or the like is preferred. From the viewpoint of improving the sensitivity of a photosensitive resin composition, the content of the sensitizer (e) in the photosensitive resin composition of the present invention based on the total amount of 100 parts by mass of the photopolymerization initiator (d-1) and the photopolymerization initiator (d-2) is preferably 1 part by mass or more, and more preferably 5 parts by mass or more. On the other hand, from the viewpoint of efficiently exhibiting a photosensitizing effect and improving the sensitivity of a photosensitive resin composition, the content of the sensitizer (e) based on the total amount of 100 parts by mass of the photopolymerization initiator (d-1) and the photopolymerization initiator (d-2) is preferably 20 parts by mass or less, and more preferably, 15 parts by mass or less.

(Filler)

The photosensitive resin composition of the present invention can further comprise a filler (f). By using the filler (f), the mechanical properties such as modulus of elasticity and chemical resistance can be improved. This makes it easier to maintain the shape of a hollow structure lid and suppress cracking. Examples of the fillers (f) include talc, a silicon oxide such as amorphous silica, crystalline silica, fused silica, or spherical silica, titanium dioxide, aluminum oxide, calcium oxide, magnesium oxide, zinc oxide, calcium carbonate, magnesium carbonate, fly ash, dewatered sludge, natural silica, synthetic silica, kaolin, clay, calcium hydroxide, aluminum hydroxide, magnesium hydroxide, mica, calcium hydroxide, aluminum silicate, magnesium silicate, calcium silicate, calcined talc, wollastonite, potassium titanate, magnesium sulfate, calcium sulfate, magnesium phosphate, sepiolite, zonolite, boron nitride, aluminum borate, glass, silica balloons, glass balloons, steel slag, copper, iron, iron oxide, sendust, alnico magnets, magnetic powder such as various ferrites, cement, Neuburg silica earth, diatomaceous earth, antimony trioxide, magnesium oxysulfate, hydrated aluminum, hydrated gypsum, alum, and barium sulfate.

Among them, as the filler (f), glass is preferred since glass can suppress light scattering and improve the resolution by adjusting the refractive index.

The glass preferably has a refractive index of 1.55 to 1.75 at a wavelength of 405 nm from the viewpoint of matching of the refractive index with the resin.

It is preferable that the glass contains silicon oxide and aluminum oxide, and that the glass also contains yttrium oxide and/or lanthanide oxide. The glass preferably contains less magnesium oxide, calcium oxide, and zinc oxide, the components of which are subject to leaching under the influence of humidity, and it is more preferable that the glass is free of these. Furthermore, it is still more preferable that the glass does not contain alkali metal oxides from the viewpoint of insulation reliability. From the viewpoint of ease of melting the glass, the glass preferably further contains boron oxide, and from the viewpoint of availability of raw materials, the glass preferably contains yttrium oxide among lanthanides and yttrium oxide.

As described above, the glass preferably contains low amounts of magnesium oxide, calcium oxide, and zinc oxide, and therefore, the total amount of magnesium, calcium, and zinc ions detected in an extraction liquid of glass subjected to a 24-hour extraction process at 121°C saturated water vapor pressure conditions is preferably 100 ppm (based on weight) or less in the glass. The measurement can be carried out by the following method. 3 g of glass and 30 mL of ultrapure water are placed in a container, sealed, and placed in an incubator at 121°C for 24 hours. The extraction liquid obtained by the ion chromatography analyzer is analyzed, and the amount of each ion extracted is converted from the calibration curve using the standard solution of each ion.

In order to obtain a glass in which the total amount of magnesium, calcium, and zinc ions detected in the extraction liquid after 24 hours of extraction treatment under saturated water vapor pressure conditions at 121°C is 100 ppm (based on weight) or less in the glass, and in which the refractive index at a wavelength of 405 nm is 1.55 to 1.75, it is preferable that 15 to 35 parts by mass of the total of yttrium oxide and lanthanide oxide are contained in 100 parts by mass of the glass, and it is more preferable that 40 to 50 parts by mass of silicon oxide, 20 to 30 parts by mass of aluminum oxide, 15 to 35 parts by mass of the total of yttrium oxide and lanthanide oxide, and 0 to 10 parts by mass of boron oxide are contained in 100 parts by mass of the glass. The above description that the total content of yttrium oxide and lanthanide oxide in 100 parts by mass of the glass is 15 to 35 parts by mass means that when the glass contains only one of yttrium oxide and lanthanide oxide, the content of the other is 15 to 35 parts by mass.

The glass in the present invention is defined as a glass having no sharp peaks (half value width of 2° or less) that indicate the crystal structure of a specific component in $2\theta$-$\theta$ powder X-ray diffraction measurement.

The refractive index of glass can be measured by the Becke method, and in the present invention, the refractive

index is defined as the result measured at a wavelength of 405 nm. When the difference in refractive indices between a glass and an organic component of a photosensitive resin composition is large, reflection and scattering occur at the interface, resulting in a decrease in the resolution. In order to obtain a favorable resolution, the absolute value of the difference between the refractive index of the (B) glass and the refractive index of an organic component of the photosensitive resin composition is preferably 0.05 or less. The refractive index of an organic component of the photosensitive resin composition depends mainly on the refractive index of the soluble polymer, and in the case of the alkali-soluble polyimide (a), the refractive index is 1.55 to 1.75. The refractive index of an organic component of a photosensitive resin composition can be determined by preparing only an organic component of the photosensitive resin composition and measuring the organic component with respect to light at a wavelength of 405 nm at 25°C by ellipsometry after a coating process and a drying process.

The average particle size of the filler (f) is preferably 10 nm or more. By setting the average particle size to 10 nm or more, addition of the filler is easier and the filler can be highly filled. On the other hand, the average particle size of the filler (f) is preferably 2 μm or less, more preferably 1 μm or less, and still more preferably 100 nm or less. The smaller the average particle size, the more favorable the smoothness of an insulating film surface after pattern processing, and the more effective it is to suppress light scattering and improve the resolution. The average particle size of the filler (f) is more preferably from 10 to 100 nm.

The average particle size of the filler (f) in the present invention is the value of 50% volume particle size measured with a particle size analyzer (Microtrac Particle Size Analyzer MODEL MT3000) utilizing the laser diffraction scattering method. The measurement is performed by taking about 1 g of a sample and dispersing the sample in purified water using ultrasonic waves with an output of 40 W for 1 to 3 minutes.

Although the shape of the filler (f) is not particularly limited, the shape of the filler (f) is preferably spherical shaped since the amount of the filler added to a photosensitive resin composition can be increased and the smoothness of an insulating film obtained by pattern processing the photosensitive resin composition is excellent.

From the viewpoint of improving mechanical properties such as modulus of elasticity and chemical resistance, the content of filler (f) used in the photosensitive resin composition of the present invention should be 30 mass parts or more, and 60 mass parts or more is preferable, relative to 100 mass parts of solid content of the photosensitive resin composition.

In order to disperse the filler (f) in a photosensitive resin composition, surface treatment with a silane coupling agent may be performed as necessary. Specific examples of the silane coupling agent that can be used include vinyltrimethoxysilane (KBM-1003), 3-glycidoxypropyltrimethoxysilane (KBM-403), 3-methacryloxypropyltrimethoxysilane (KBM-503), N-2-(aminoethyl)-3-aminopropyltrimethoxysilane (KBM-603), and N-phenyl-3-aminopropyltrimethoxysilane (KBM-603) manufactured by Shin-Etsu Chemical Co., Ltd. The surface treatment of the filler (f) can be performed by a dry surface treatment in which a silane coupling agent and a small amount of water are added to the filler (f) and stirred.

(Other Contained Substances)

The photosensitive resin composition of the present invention may further contain, as necessary, a cross linking agent other than the thermally crosslinkable compound (c), a photopolymerization initiator other than the photopolymerization initiator (d-1) and the photopolymerization initiator (d-2), a thermal polymerization initiator, a polymerization inhibitor, a colorant, a surfactant, a silane coupling agent, a titanium chelating agent, a crosslinking accelerator, a dissolution regulator, a stabilizer, a defoaming agent, and an organic solvent.

Examples of photoinitiators other than the photopolymerization initiator (d-1) and the photopolymerization initiator (d-2) include an oxyme, a benzophenone, a benzylidene, a coumarin, an anthraquinone, a benzoin, a thioxanthone, a mercapt, a glycine oxime, a benzyl dimethyl ketal, an alpha-hydroxyalkylphenone, an alpha-aminoalkylphenone, an acyl phosphine oxide, 2,2'-bis(o-chlorophenyl)-4,4',5,5'-tetraphenylbiimidazole. The photosensitive resin composition of the present invention may contain two or more of these as photoinitiators other than the photopolymerization inhibitor (d-1) and the photopolymerization initiator (d-2).

Among them, an oxime or an acyl phosphine oxide is preferred. Examples of the oxime include 1-phenyl- 1,2-butanedione-2-(o-methoxycarbonyl)oxime, 1-phenyl-1,2-propanedione-2-(o-methoxycarbonyl)oxime, 1-phenyl-1,2-propanedione-2-(*o*-ethoxycarbonyl)oxime, 1-phenyl-1,2-propanedione-2-(*o*-benzoyl)oxime, bis($\alpha$-isonitrosopropiophenone oxime) isophthalic, 1,2-octanedione, 1-[4-(phenylthio)phenyl-, 2-(*o*-benzoyloxime), ethanone, 1-[9-ethyl-6-(2-methylbenzoyl)-9H-carbazol-3-yl]-, 1-(*O*-acetyloxime). Examples of the acyl phosphine oxide include 2,4,6-trimethylbenzoyl diphenyl-phosphine oxide and bis(2,4,6-trimethylbenzoyl)-phenyl phosphine oxide.

Since the photosensitive resin composition of the present invention contains a polymerization inhibitor, the concentration of excitons is regulated, thereby suppressing excessive photoresponsiveness and allowing a wider exposure margin. By containing a colorant, the photosensitive resin composition of the present invention acts to suppress stray light from a light-emitting area when used as an insulating layer for organic field emission devices, and acts as a blindfold to hide circuit wiring on circuit boards when used as a solder resist for circuit boards. Examples of the colorant

include a dye and a pigment. Examples of the dye include a thermoluminescent dye. Examples of the pigment include an inorganic pigment and an organic pigment. As such a colorant, one that is soluble in an organic solvent that dissolves the alkali-soluble polyimide (a) and is compatible with the alkali-soluble polyimide (A) is preferable.

When the photosensitive resin composition of the present invention contains a surfactant, silane coupling agent, titanium chelating agent, or the like, the adhesiveness with a substrate can be improved. As the organic solvent in the present invention, one that dissolves a photosensitive resin composition is preferable. Examples of such an organic solvent include an ether, an acetate, a ketone, an aromatic hydrocarbon, *N*-methyl-2-pyrrolidone, *N*-cyclohexyl-2-pyrrolidone, *N,N*-dimethylformamide, *N,N*-dimethylacetamide, dimethyl sulfoxide, γ-butyrolactone. The photosensitive resin composition of the present invention may contain two or more types of these as organic solvents.

Examples of the ether include ethylene glycol monomethyl ether, ethylene glycol monoethyl ether, propylene glycol monomethyl ether, propylene glycol monoethyl ether, ethylene glycol dimethyl ether, ethylene glycol diethyl ether, and ethylene glycol dibutyl ether. Examples of the acetate include ethylene glycol monoethyl ether acetate, propylene glycol monomethyl ether acetate, propyl acetate, butyl acetate, isobutyl acetate, 3-methoxybutyl acetate, 3-methyl-3-methoxybutyl acetate, methyl lactate, ethyl lactate, butyl lactate. Examples of the ketone include acetone, methyl ethyl ketone, acetyl acetone, methyl propyl ketone, methyl butyl ketone, methyl isobutyl ketone, cyclopentanone, and 2-heptanone. Examples of the aromatic hydrocarbon include butyl alcohol, isobutyl alcohol, pentanol, 4-methyl-2-pentanol, 3-methyl-2-butanol, 3-methyl-3-methoxybutanol, diacetone alcohol, and other alcohols, toluene, and xylene.

< Method for Preparing Photosensitive Resin Composition >

The photosensitive resin composition of the present invention can be obtained, for example, by mixing and dissolving the alkali-soluble polyimide (a), the unsaturated bond-containing compound (b), the thermally crosslinkable compound (c), the photopolymerization initiator (d-1), the photopolymerization initiator (d-2) and, if necessary, the sensitizer (e), and other additives. The photosensitive resin composition of the present invention can be obtained, for example, by mixing and dissolving a photosensitive resin composition containing the alkali-soluble polyimide (a), the unsaturated bond-containing compound (b), the thermally crosslinkable compound (c), two or more oxime ester photoinitiators (d), and, if necessary, the sensitizer (e) and other additives. The above-described components of the photosensitive resin composition of the present invention can be dissolved in an organic solvent, if necessary, to make a solution with a solid concentration of about 20 to 70% by mass.

The photosensitive resin composition of the present invention may be filtered using a filter paper or a filter. The method of filtering the photosensitive resin composition is not particularly limited, and a method of filtering by pressurized filtration using a filter with a retained particle size of 0.4 μm to 10 μm is preferable.

< Form of Photosensitive Resin Composition >

The form of the photosensitive resin composition of the present invention can be selected from a sheet shape, a rod shape, a spherical shape, a pellet shape, and the like, depending on the application. The term "sheet" herein includes a membrane, a film, a plate, and the like. In the present invention, a sheet form is preferable as the form of the photosensitive resin composition. In other words, a photosensitive resin sheet in which the photosensitive resin composition of the present invention is formed into a sheet form is preferable.

The photosensitive resin sheet of the present invention can be obtained, for example, by applying the photosensitive resin composition of the present invention onto a support, followed by drying if necessary.

The photosensitive resin sheet of the present invention is preferably a photosensitive resin sheet including: a support; and a photosensitive resin layer formed on the support using a photosensitive resin composition.

Examples of the support include a polyethylene terephthalate (PET) film, a polyphenylene sulfide film, and a polyimide film. On a bonding surface between the support and the photosensitive resin sheet, a surface treatment with silicone, a silane coupling agent, an aluminum chelating agent, polyurea, or the like may be applied to improve the adhesiveness and the peelability between them.

The thickness of the support is preferably 10 μm or more from the viewpoint of workability. On the other hand, from the viewpoint of reducing cracks in the photosensitive resin when the film is peeled off, the thickness of the support is preferably 50 μm or less, more preferably 40 μm or less, and particularly preferably 30 μm or less.

From the viewpoint of suppressing light scattering and improving resolution when the photosensitive resin layer is exposed through the support, the haze of the support at a wavelength of 405 nm is preferably 1% or less. The haze at a wavelength of 405 nm, or $HAZE_{405}$, can be obtained by measuring the transmittance using a spectrophotometer and substituting the value into the following formula.

$$HAZE_{405} = T2 - T1$$

T1 indicates the transmittance at a wavelength of 405 nm measured without an integrating sphere attached to the spectrophotometer, and T2 indicates the transmittance at a wavelength of 405 nm measured with an integrating sphere attached to the spectrophotometer.

The photosensitive resin sheet of the present invention may include a protective film for protecting a photosensitive resin layer. This protective film can protect the surface of a photosensitive resin layer from contaminants such as dust and dirt in the air.

Examples of the protective film in the present invention include a polyethylene film, a polypropylene (PP) film, a polyester film, and a polyvinyl alcohol film. The protective film preferably has enough peeling strength to prevent the photosensitive resin layer and the protective film from being easily peeled off.

Examples of the method of applying a photosensitive resin composition to a support to produce the photosensitive resin sheet of the present invention include rotary coating using a spinner, spray coating, roll coating, screen printing, blade coater, die coater, calender coater, meniscus coater, bar coater, roll coater, comma roll coater, gravure coater, screen coater, and slit die coater.

Although the coating thickness of the photosensitive resin composition varies depending on the coating method, the solid concentration, and the viscosity of the photosensitive resin composition to be coated, from the viewpoint of ensuring the thickness of a cured film, the film thickness after drying of the photosensitive resin composition is preferably adjusted to 0.5 μm or more, more preferably adjusted to 10 μm or more, and still more preferably adjusted to 12 μm or more. On the other hand, from the viewpoint of reducing the thickness of the cured film, the film thickness after drying of the photosensitive resin composition is preferably adjusted to 150 μm or less, more preferably adjusted to 100 μm or less, and still more preferably adjusted to 50 μm or less. The thickness of the coating film of the photosensitive resin composition is more preferably 12 to 150 μm after coating and drying on a base material, and still more preferably 12 to 50 μm after coating and drying on a base material.

Examples of drying devices for drying the applied photosensitive resin composition include an oven, a hot plate, and infrared rays. The drying temperature and drying time can be in a range that enables the organic solvent to be volatilized, and they are preferably set appropriately in such a range that a photosensitive resin sheet becomes uncured or semi-cured. Specifically, the drying temperature is preferably in a range of 40°C to 120°C, and the drying time is preferably in a range of 1 minute to several tens of minutes. The drying temperature may be raised in stages by combining temperatures within this range. For example, when drying a photosensitive resin composition, the photosensitive resin composition may be heated at 50°C, 60°C, and 70°C for one minute each.

## < Cured Product of Photosensitive Resin Composition >

By heat curing the photosensitive resin composition of the present invention, a cured product of this photosensitive resin composition can be obtained. In heat curing of the photosensitive resin composition, the heat curing temperature is preferably within a range of 120°C to 400°C. The form of the cured product of the photosensitive resin composition is not particularly limited and can be selected according to the application such as sheet, rod, sphere, pellet, or the like. In the present invention, the cured product is preferably in the form of a film.

The cured product obtained by heat treatment preferably has a high modulus of elasticity at 180°C from the viewpoint of the heat resistance and the pressure resistance. The higher the modulus of elasticity at 180°C, the easier it is for a cured film to endure a sealing process of a hollow structure. For the photosensitive resin composition of the present invention, the modulus of elasticity at 180°C of a cured product is preferably 3 GPa or higher, more preferably 5 GPa or higher, and still more preferably 7 GPa.

The cured product of the photosensitive resin composition of the present invention can be suitably used for a lid portion of a hollow structure since the lid of the hollow structure can be formed with high sensitivity and ease. By pattern processing of the photosensitive resin composition, the shape of the cured product of the photosensitive resin composition can also be selected according to the application, such as forming a lid of a hollow structure, forming a protective film on a wall surface, forming a via hole for conduction, adjusting impedance, capacitance, or internal stress, and providing a heat dissipation function.

## < Processing Examples of Photosensitive Resin Sheet >

Next, a method of pattern processing the photosensitive resin sheet of the present invention to form a hollow structure will be explained by way of example.

The method for producing a hollow structure, the method comprising: a layering process (A) in which the photosensitive resin layer is formed by layering a photosensitive resin sheet on a convex portion provided to form a hollow structure on a substrate in such a manner to form a lid of the hollow structure; an exposure process (B) in which an exposed portion is photocured by irradiating an active ray to a predetermined portion of the photosensitive resin layer; a baking process (C) in which the exposed portions is promoted curing by heating the photosensitive resin layer; a

peeling process (D) in which a support is peeled off; a development process (E) in which a portion of the photosensitive resin layer other than the exposed portion is removed using a developer, if necessary; and a heat curing process (F) in which a resin cured product is formed by heat curing the exposed portion of the photosensitive resin layer. Through these processes, a desired pattern for producing a hollow structure lid can be formed on the convex portion of the substrate.

Each of the processes will be described below. Fig. 1 illustrates one suitable processing method for the photosensitive resin sheet of the present invention.

(Layering Process (A))

When a photosensitive resin sheet includes a protective film, the protective film is peeled off. The photosensitive resin sheet and a substrate with a convex portion are arranged in such a manner that they face each other, and are pasted together by thermocompression bonding. (A) in Fig. 1 illustrates a layering process. A convex portion of the substrate may be formed by printing a resin material on the substrate or by photolithography of a photosensitive material, or a convex portion may be formed relative to the substrate by forming concavities by scraping the substrate with dry etching or the like. The convex portion of the substrate corresponds to the outer wall of the hollow structure made of the photosensitive resin, and a space surrounded by the convex portion is formed. The space surrounded by the convex portions is, for example, a space of 100 to 10,000 μm per side and a height of 5 μm to 100 μm. The inside of the space surrounded by the convex portion may include an independent convex portion, or a convex portion that is continuous with the outer wall. A functional portion of an electronic component such as a comb-shaped electrode of a surface acoustic wave filter or a crystal of a crystal oscillator is preferably placed inside the space surrounded by the convex portion. In terms of the size and the shape of the substrate, a circular substrate with a diameter of 100 to 300 mm or a square substrate with a side of 100 to 300 mm is used, and the above-described convex portions are arranged on all or part of such a substrate. Examples of the method of pasting photosensitive resin layers together include a press and a roll laminator. A roll laminator, which enables continuous roll-to-roll pasting, is preferable from the viewpoint of mass productivity. The temperature for pasting is preferably 40°C or higher since the photosensitive resin layer does not sufficiently exhibit adhesiveness if the temperature is too low, and preferably 80°C or lower since the photosensitive resin layer is excessively softened and adheres to the substrate if the temperature is too high. When the pasting pressure is too high, the photosensitive resin layer is excessively pushed in and adheres to the substrate, and therefore, the pressure is preferably 0.2 MPa or less.

(Exposure Process (B))

On the photosensitive resin sheet formed by the above-described method, a mask with a desired pattern is formed, and chemical rays are irradiated to the photosensitive resin sheet through the mask to expose this photosensitive resin sheet in a pattern. (B) in Fig. 1 illustrates an exposure process. Examples of the chemical rays used for exposure include ultraviolet rays, visible light, electron beams, and X-rays. In the present invention, the i-ray (365 nm), the h-ray (405 nm), and the g-ray (436 nm) of a mercury lamp are preferably used. When the support is a material that is transparent to these rays, exposure may be carried out without peeling the support from the photosensitive resin sheet. From the viewpoint of suppressing cracks in the photosensitive resin layer, it is preferable to expose without peeling the support from the photosensitive resin sheet.

(Baking Process (C))

When formation of a hollow structure is facilitated, such as reduction of cracks of the photosensitive resin layer and reduction of depression of a lid, it is preferable to carry out the baking process (C) in which the photosensitive resin sheet is heated before development. (C) in Fig. 1 illustrates a baking process. In the baking process, the baking temperature is preferably 50°C or higher, and more preferably 60°C or higher, from the viewpoint of accelerating curing. On the other hand, the baking temperature is preferably 180°C or lower, and more preferably 120°C or lower, from the viewpoint of reducing depression of the photosensitive resin layer. Further preferably, the baking temperature in the baking process (C) is 60 to 180°C. The baking time is preferably 5 seconds to several hours. In the baking process (C), the baking may be carried out without peeling the support from the photosensitive resin sheet. From the viewpoint of suppressing cracks and depression of the photosensitive resin layer, baking without peeling off the support is preferable.

(Peeling Process (D))

After the layering process (A), the support is peeled off from the photosensitive resin layer. (D) in Fig. 1 illustrates a peeling process. The peeling process (D) may be carried out either before or after the exposure process (B). From the viewpoint of suppressing cracks in the photosensitive resin layer, the support is preferably peeled off after the

exposure process (B). The peeling process (D) may be performed either before or after the baking process (C), and from the viewpoint of suppressing depression of the photosensitive resin layer, peeling after the baking process (C) is preferable.

(Development Process (E))

Next, the unexposed portion of the above-described photosensitive resin sheet is removed using a developer to form a pattern on the above-described photosensitive resin sheet. (E) in Fig. 1 illustrates a development process. For this developer, an aqueous solution of tetramethylammonium or an aqueous solution of a compound that exhibits alkalinity such as diethanolamine, diethylaminoethanol, sodium hydroxide, potassium hydroxide, sodium carbonate, potassium carbonate, triethylamine, diethylamine, methylamine, dimethylamine, dimethylaminoethyl acetate, dimethylaminoethanol, dimethylaminoethyl methacrylate, cyclohexylamine, ethylenediamine, or hexamethylenediamine is preferable. If necessary, a polar solvent such as *N*-methyl-2-pyrrolidone, *N*,*N*-dimethylformamide, *N,N*-dimethylacetamide, dimethyl sulfoxide, γ-butyrolactone, or dimethylacrylamide, an alcohol such as methanol, ethanol, or isopropanol, an ester such as ethyl lactate or propylene glycol monomethyl ether acetate, a ketone such as cyclopentanone, cyclohexanone, isobutyl ketone, or methyl isobutyl ketone, or the like may be added to these alkaline aqueous solutions.

Examples of a method of developing a photosensitive resin sheet include a method of spraying the above-described developer on a coated surface, a method of immersing a coated surface in a developer, a method of applying an ultrasonic wave while immersing a coated surface in a developer, and a method of spraying a developer while rotating a substrate. "Coated surface" herein refers to the surface of a substrate portion that is covered by a patterned photosensitive resin sheet. The conditions such as the development time and the temperature of a developer can be set within a range where an unexposed portion of a photosensitive resin sheet is removed. In order to process fine patterns on a photosensitive resin sheet or to remove residues between the patterns, the photosensitive resin sheet may be further developed even after an unexposed portion has been removed.

(Rinsing Process)

After developing the photosensitive resin sheet, a rinsing process may be carried out on the substrate. For a rinsing liquid used in this rinsing process, water is preferable. If necessary, an alcoholic such as ethanol or isopropyl alcohol, an ester such as ethyl lactate or propylene glycol monomethyl ether acetate, or the like may be added to the rinsing liquid (water).

(Heat Curing Process (F))

After developing the photosensitive resin sheet, the photosensitive resin sheet on the substrate is heat treated under temperature conditions of 120°C to 400°C to form a cured film. (F) in Fig. 1 illustrates a heat curing process. In this heat treatment (curing), temperatures may be selected and increased step by step, or a certain temperature range may be selected and increased continuously. In this heat treatment, the heating temperature is more preferably 150°C or higher, and still more preferably 180°C or higher. On the other hand, the heating temperature is preferably 300°C or lower, and more preferably 250°C or lower. The time for heat treatment is preferably 5 minutes to 5 hours. Examples of such a heat treatment include a method of heat treating at 130°C and 200°C for 30 minutes each, or a method of linearly increasing the temperature from room temperature to 250°C over a period of 2 hours.

< Hollow Structure >

The hollow structure of the present invention is a hollow structure formed by a convex portion provided on a substrate of an electronic component and a lid, wherein the lid is composed of a photosensitive resin composition layer of a photosensitive resin sheet.

From the viewpoint of maintaining the shape of a hollow structure lid, the film thickness of a cured product of a photosensitive resin composition is preferably 0.5 μm or more, more preferably 10 μm or more, and still more preferably 12 μm or more. On the other hand, from the viewpoint of miniaturization of a hollow structure, the film thickness of a cured product of a photosensitive resin composition is preferably 150 μm or less, more preferably 100 μm or less, and still more preferably 50 μm or less.

< Electronic Component >

The electronic component of the present invention has a hollow structure formed by a convex portion provided on a substrate of an electronic component and a lid, wherein the lid is composed of a photosensitive resin composition

layer of a photosensitive resin sheet. Examples of the electronic component having a hollow structure include a surface acoustic wave filter and a MEMS, and by applying the photosensitive resin sheet of the present invention, short processing time can be achieved. The surface acoustic wave filter is a noise removal filter that utilizes the vibration of a piezoelectric material to extract only a signal at a specific frequency. Since a surface acoustic wave filter requires a space to vibrate a piezoelectric material and an electrode, a hollow structure covering the piezoelectric material and the electrode is essential, as illustrated in Fig. 1.

Examples

The present invention will be described in detail by means of Examples and Comparative Examples below. An alkali-soluble polyimide (a), a photopolymerization initiator (d-1), and a photopolymerization initiator (d-2) used in the following Examples and Comparative Examples were synthesized by the following method.

(Synthesis Example 1)

A synthesis method of Polyimide A1, an alkali-soluble polyimide (a) of Synthesis Example 1 in the present invention will be described. In the synthesis method of polyimide A1, 2,2-bis(3-amino-4-hydroxyphenyl)hexafluoropropane (32.96 g (0.090 moles)) and 1,3-bis(3-aminopropyl)tetramethyldisiloxane (1.24 g (0.005 moles)) were dissolved in *N*-methyl-2-pyrrolidone (100 g) under a dry nitrogen stream. Hereafter, "*N*-methyl-2-pyrrolidone" will be referred to as "NMP". To this solution, bis(3,4-dicarboxyphenyl) ether dianhydride (31.02 g (0.100 mole)) was added together with NMP (30 g) and stirred at 20°C for 1 hour, followed by stirring at 50°C for 4 hours. To this stirred solution, 3-aminophenol (1.09 g (0.010 mole)) was added and stirred at 50°C for 2 hours, followed by stirring at 180°C for 5 hours to obtain a resin solution. Next, this resin solution was put into water (3 L) to produce a white precipitate. This white precipitate was collected by filtration, washed three times with water, and then dried in a vacuum dryer at 80°C for 5 hours. As a result, a powder of an alkali-soluble polyimide (polyimide A1) having the structure represented by the general formula (4) was obtained.

The imidization rate of the obtained Polyimide A1 was 94%. The solubility of Polyimide A1 in a tetramethylammonium aqueous solution (2.38% by mass) at 23°C was 0.1 g/100 g or higher.

(Synthesis Example 2)

Photoinitiator B1 having the following chemical structure, which is the photopolymerization initiator (d-1) of Synthesis Example 2 in the present invention, was synthesized by the method described in WO 2015/036910.

[Chem. 11]

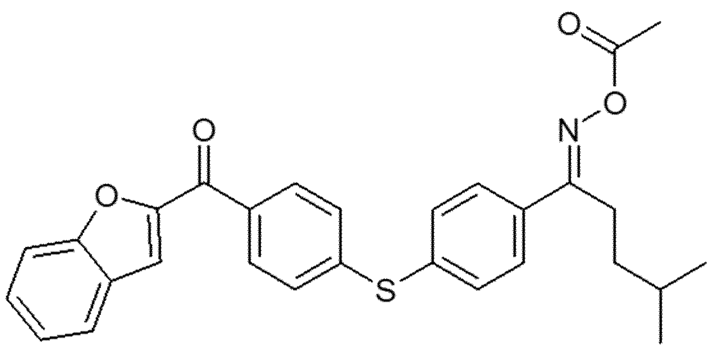

(Synthesis Example 3)

Photoinitiator B2 having the following chemical structure, which is the photopolymerization initiator (d-1) of Synthesis Example 3 in the present invention, was synthesized by the method described in WO 2012/002028.

[Chem. 12]

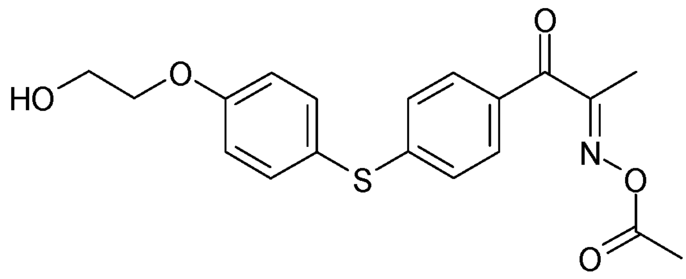

(Synthesis Example 4)

Photoinitiator C1 having the following chemical structure, which is the photopolymerization initiator (d-2) of Synthesis Example 4 in the present invention, was synthesized by the method described in WO 2008/078678.

[Chem. 13]

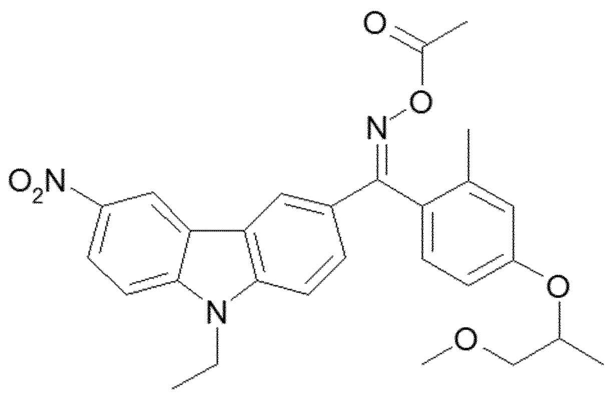

(Other Materials)

On the other hand, each of the other materials used in each of the following Examples and Comparative Examples are described below.

As the unsaturated bond-containing compound (b), BP-6EM (trade name, ethylene oxide-modified bisphenol A dimethacrylate, manufactured by kyoeisha Chemical Co., Ltd.) and MOI-BP (trade name, 2-[(3,5-dimethylpyrazolyl)carbonylamino]ethyl methacrylate, manufactured by Showa Denko K.K.) are used.

As the thermally crosslinkable compound (c), HMOM-TPHAP (trade name, 4,4',4"-ethylidynetris[2,6-bis(methoxymethyl)phenol], manufactured by Honshu Chemical Industry Co., Ltd.

As a photopolymerization initiator other than the photopolymerization initiator (d-1) and the photopolymerization initiator (d-2), or another photopolymerization initiator (d'), "IRGACURE" (registered trademark) OXE01 (trade name, manufactured by BASF, 1,2-octanedione, 1-[4-(phenylthio)phenyl-, 2-(O-benzoyloxime)), which is an oxime ester photopolymerization initiator, "IRGACURE" OXE02 (trade name, manufactured by BASF, ethanone, 1-[9-ethyl-6-(2-methylbenzoyl)-9H-carbazol-3-yl]-, 1-(O-acetyloxime)), which is an oxime ester photopolymerization initiator, and "IRGACURE" 369 (trade name, manufactured by BASF, 2-benzyl-2-dimethylamino-1-(4-morpholinophenyl)-butanone-1), which is not an oxime ester photopolymerization initiator, are used.

[Chem. 14]

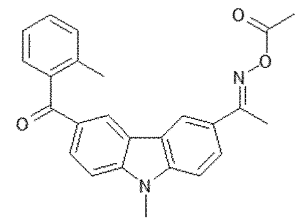

"IRGACURE" OXE-02

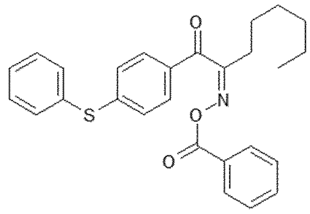

"IRGACURE" OXE-01

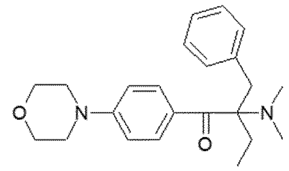

"IRGACURE" 369

As the sensitizer (e), DETX-S (trade name, manufactured by Nippon Kayaku Co., Ltd., 2,4-diethylthioxanthen-9-one) is used.

As the filler (f), the following three types are used.

Glass 1:

Silicon oxide 45% by weight, aluminum oxide 25% by weight, boron oxide 4% by weight, Yttrium oxide 26% by weight, refractive index (wavelength 405nm) 1.61, average particle size 1.2μm, extracted ion content (magnesium ion + calcium ion + zinc ion) 7 ppm (based on weight)

Sub-silica 1:

SO-E2 (product name, manufactured by Admatechs Company Limited), refractive index (wavelength 405 nm) 1.47, average particle size 0.5 μm, extracted ion amount (magnesium ion + calcium ion + zinc ion) 2 ppm (based on weight)

Nano-silica 1

YA050C (product name, Admatechs Company Limited), refractive index (wavelength 405 nm) 1.47, average particle size 50 nm, amount of extracted ions (magnesium ion + calcium ion + zinc ion) 2 ppm (based on weight)

In each of the following Examples and Comparative Examples, a silane coupling agent is used as the other additive (g). As the silane coupling agent, IM-1000 (product name, manufactured by JX Nippon Mining & Metals Corporation) is used.

An evaluation method of each photopolymerization initiator in each of the following Examples and Comparative Examples is described below.

< Photobleaching Property of Photopolymerization Initiator >

Photopolymerization initiator B1 was dissolved in ethyl lactate and adjusted to a concentration of 0.1 g/L. Then, the solution was injected into a quartz cell having a thickness of 0.2 cm, and the absorbance before exposure was measured using a spectrophotometer (manufactured by Hitachi High-Tech Science Corporation, U-3900). The quartz cell containing the solution was then exposed at 1,000 mJ/$cm^2$ (in terms of i-line) using an exposure system (SME-150GA-TRJ, manufactured by Seiwa Optical Co., Ltd.). Then, the absorbance after exposure was measured using a spectrophotometer (manufactured by Hitachi High-Tech Science Corporation, U-3900). The absorbance Abs (before exposure) before exposure at which the absorbance was 20% in the longer wavelength region than the maximum absorption wavelength when the absorbance at the maximum absorption wavelength before exposure was set to 100% was obtained. When there were two or more maximum absorption wavelengths, the maximum absorption wavelength in the long wavelength region was used. Next, the absorbance Abs (after exposure) after exposure at the same wavelength as Abs (before exposure) is obtained, and Abs (before exposure) and Abs (after exposure) were compared. The presence or absence of a photobleaching property was evaluated according to the following criteria. Other photopolymerization initiators were evaluated in the same way as above. The evaluation results of each photopolymerization initiator are shown in Table 1 below. Yes: Abs (before exposure) > Abs (after exposure), and photobleaching property. None: Abs (before exposure) ≤ Abs (after exposure) and no photobleaching property.

< Molar Absorption Coefficient of Photopolymerization Initiator >

Photopolymerization initiator B1 was dissolved in ethyl lactate and adjusted to a concentration of 0.1 g/L. Then, the solution was injected into a quartz cell having a thickness of 0.2 cm, and the absorbance $Abs_{405}$ at a wavelength of

405 nm was measured using a spectrophotometer (manufactured by Hitachi High-Tech Science Corporation, U-3900). For the other photopolymerization initiators, the $Abs_{405}$ was also measured by the above-described method. The molar absorption coefficient $\varepsilon_{405}$ at a wavelength of 405 nm was then calculated from the Lambert-Beer's equation below. Other photopolymerization initiators were evaluated in the same way as above. The evaluation results of each photopolymerization initiator are shown in Table 1 below.

$$\varepsilon_{405} = Abs_{405} / (C \cdot l)$$

C is the concentration of a solution and 1 is the optical path length of a measurement sample.

[Table 1]

| | Photopolymerization initiator B1 | Photopolymerization initiator B2 | Photopolymerization initiator C1 | IRGACURE OXE01 | IRGACURE OXE02 |
|---|---|---|---|---|---|
| Photobleaching property | Yes | Yes | None | Yes | None |
| Molar absorption coefficient $\varepsilon_{405}$ [L/(mol·cm)] | 120 | 150 | 3900 | 100 | 41 |

< Resolution >

The protective film of the photosensitive resin sheet obtained by Example 3 was peeled off, and the peeled surface of the photosensitive resin sheet was laminated onto a 4-inch silicon wafer using a laminating device (manufactured by Takatori Corporation, VTM-200M) under the following conditions: stage temperature 80°C, roll temperature 80°C, vacuum 150 Pa, laminating speed 5 mm/sec, and pasting pressure 0.3 MPa. Using an exposure system (manufactured by Seiwa Optical Co., Ltd., SME-150GA-TRJ), exposure was carried out at 300 mJ/cm$^2$ (in terms of h-line) with a support film and a photomask in contact. After peeling off the support film, the substrate with the resin film was heat treated at 200°C for 1 hour in an inert oven under a nitrogen atmosphere with an oxygen concentration of 100 ppm or less.
The protective film of the photosensitive resin sheet obtained by each of the Examples and Comparative Examples was peeled off, and the peeled surface of the photosensitive resin sheet was laminated onto a substrate including a resin film using a laminating device (manufactured by Takatori Corporation, VTM-200M) under the following conditions: stage temperature 80°C, roll temperature 80°C, vacuum 150 Pa, laminating speed 5 mm/sec, and lamination pressure 0.3 MPa. A photomask with patterns of via = 5, 10, 15, 20, 25, 30, 35, 40, 45, 50, 55, 60, 65, 70, 75, 80, 85, 90, 95, and 100 μmΦ was set in an exposure system (manufactured by Seiwa Optical Co., Ltd., SME-150GA-TRJ), and exposure was carried out at 300 mJ/cm$^2$ (in terms of h-line) with a support film and a photomask in contact. After exposure, the photosensitive resin layer was heated on a hot plate at 70°C for 10 minutes. Then, after peeling off the support film, an unexposed portion of the photosensitive resin layer was removed by shower development using a 2.38% aqueous solution of tetramethylammonium hydroxide for 60 seconds. Furthermore, a rinse treatment with water was carried out for 30 seconds, followed by spin drying. The pattern formed on the photosensitive resin composition layer was then observed under a microscope, and evaluated in accordance with the following criteria. The higher the score is, the better the resolution is, which means that the pattern is excellent.

4: The minimum dimension of the via was 30 μmφ or less.
3: The minimum dimension of the via was 35 μmφ to 50 μmφ.
2: The minimum dimension of the via was 55 μmφ to 70 μmφ.
1: The minimum dimension of the via was 75 μmφ or larger, or there was no open via.

< Crack >

The protective film of the photosensitive resin sheet obtained in Example 3 was peeled off, and the peeled surface of the photosensitive resin sheet was laminated onto a 4-inch silicon wafer using a laminating device (manufactured by Takatori Corporation, VTM-200M) under the following conditions: stage temperature 80°C, roll temperature 80°C, vacuum 150 Pa, laminating speed 5 mm/sec, and lamination pressure 0.3 MPa. A mask with square patterns of 100 μm width and 500 μm per side, arranged 50 × 50 vertically and horizontally at 100 μm intervals, was set on an exposure system (manufactured by Seiwa Optical Co., Ltd., SME-150GA-TRJ), and exposure was carried out at 300 mJ/cm$^2$ (in terms of h-line) with a support film and the photomask in contact. After exposure, the photosensitive resin layer was heated on a hot plate at 70°C for 10 minutes. Next, after peeling off the support film, an unexposed portion of the photosensitive resin layer was removed by shower development using a 2.38% aqueous solution of tetramethylammonium hydroxide for 60 seconds. Furthermore, rinsing with water was carried out for 30 seconds, followed by spin drying. Then, in an inert oven, under a nitrogen atmosphere with an oxygen concentration of 100 ppm or less, a substrate with a convex pattern formed thereon was obtained by heat treatment at 200°C for 1 hour. Fig. 4 is a schematic diagram of the convex portion pattern. Fig. 6 is a schematic diagram of a wafer with a convex pattern formed thereon.
The protective film of the photosensitive resin sheet obtained by each of the Examples and Comparative Examples was peeled off, and the peeled surface of the photosensitive resin sheet was laminated onto a substrate including a resin film using a laminating device (manufactured by Takatori Corporation, VTM-200M) at a stage temperature of 60°C, a roll temperature of 60°C, a laminating speed of 20 mm/sec, a lamination pressure of 0.1 MPa, and under atmosphere. A photomask with 50 × 50 square patterns of 600 μm per side arranged at intervals of 200 μm was set in an exposure system (SME-150GA-TRJ, manufactured by Seiwa Optical Co., Ltd.), and exposure was carried out at 300 mJ/cm$^2$ (in terms of h-line) with a support film and the photomask in contact. During this exposure, the position of the photomask was adjusted in such a manner that the center of the pattern of a lid was positioned at the center of a convex portion pattern in order to form a hollow structure. After exposure, the photosensitive resin layer was heated on a hot plate at 70°C for 10 minutes. Next, after peeling off the support film, an unexposed portion of the photosensitive resin layer was removed by shower development using a 2.38% aqueous solution of tetramethylammonium hydroxide for 60 seconds. The film was then rinsed with water for 30 seconds and dried by spin drying. Then, in an inert oven, under a nitrogen atmosphere with an oxygen concentration of 100 ppm or less, a hollow structure was obtained by heat treatment at 200°C for 1 hour. Fig. 5 is a schematic diagram of the pattern of a lid formed on a convex portion pattern. For any 100 locations in the substrate where the hollow structure was formed, the presence or absence of cracks in the lid made

of the photosensitive resin layer was observed under a microscope. Fig. 2 illustrates a schematic diagram of cracks in the photosensitive resin layer. The photosensitive resin layer, which was photo-cured by exposure, cracked and broke. The incidence of cracks was calculated and evaluated according to the following criteria. The higher the score, the fewer the defects, which means that the substrate is excellent.

5: Incidence of cracking was less than 3%.
4: Incidence of cracking was 3% to less than 6%.
3: Incidence of cracking was 6% to less than 10%.
2: Incidence of cracking was 10% to less than 15%.
1: Incidence of cracking was 15% or more.

< Depression >

The deflection of the lid made of the photosensitive resin layer was measured from sectional observation at any ten points of the hollow structure formed by the same method as in the case of the evaluation of cracks described above. Fig. 3 is a schematic diagram illustrating the deflection of a lid formed of a photosensitive resin layer. The maximum deflection of the lid with respect to the bonding surface of the convex portion and the photosensitive resin layer was defined as the deflection amount, and the average value was calculated. The calculated deflection amount was evaluated in accordance with the following criteria. The higher the score, the smaller the depression, which means the lid is superior.

5: The deflection amount is 3 μm or less.
4: The deflection amount is 3 μm to less than 6 μm.
3: The deflection amount is 6 μm to less than 10 μm.
2: The deflection amount is 10 μm to less than 12 μm.
1: The deflection amount is 12 μm or more.

< Surface Roughness and Thickness Loss >

For a hollow structure formed in the same method as in the case of the above-described crack evaluation, the presence or absence of surface roughness on a lid made of a photosensitive resin layer was confirmed with a microscope. Furthermore, regarding the thickness loss of a lid made of a photosensitive resin layer, the film thickness was measured by sectional observation, and evaluation was performed in accordance with the following criteria. The higher the score, the better the surface curing properties, which means that the lid is excellent.

3: No surface roughness occurred and the film thickness was 10 μm or more.
2: Surface roughness occurred, and the film thickness was 10 μm or more.
1: Surface roughness occurred, and the film thickness was less than 10 μm.

< Pattern Shape >

For a hollow structure formed in the same method as in the case of the above-described crack evaluation, the pattern shape of a lid made of a photosensitive resin layer was sectionally observed. The taper angle between the convex portion and a side of the lid was measured, and a sectional shape of the pattern was evaluated using the following criteria. The higher the score, the more favorable the pattern shape, which means the pattern is excellent.

2: Rectangular or tapered shape with a taper angle of 90° or less.
1: Reversed taper shape with a taper angle exceeding 90°.

< 180°C Modulus of Elasticity >
A photosensitive resin sheet obtained by each of Examples and Comparative Examples was exposed at 300 mJ/cm$^2$ (in terms of h-line) from the support side using an exposure system (manufactured by Seiwa Optical Co., Ltd., SME-150GA-TRJ). The protective film was then peeled off, and the film was heat treated at 200°C for 1 hour in an inert oven under a nitrogen atmosphere with an oxygen concentration of 100 ppm or less. Then, the support was peeled off and a single film sample of cured product was obtained. The single film sample was cut into 5 × 40 mm with a single blade and tested using DMA (manufactured by Hitachi High-Tech Science Corporation, DMS6100) under the following conditions: sample length: 10 mm, temperature condition: 25°C → 350°C (5°C/min), strain amplitude: 5 μm, minimum tension/pressure: 10 mN, tension-pressure gain: 1.5, and initial force amplitude: 50 mN, and the modulus of elasticity at 180°C was measured.

< Example 1 >

In Example 1 of the present invention, Polyimide A1 of Synthetic Example 1 was used as the alkali-soluble polyimide (a), BP-6EM and MOI-BP were used as the unsaturated bond-containing compounds (b), HMOM-TPHAP was used as the thermally crosslinkable compound (c), Photoinitiator B1 of Synthetic Example 2 was used as the photopolymerization initiator (d-1), and Photoinitiator C1 of Synthetic Example 4 was used as the photopolymerization initiator (d-2). DETX-S was used as the sensitizer (e), and IM-1000 was used as the silane coupling agent.

Specifically, Polyimide A1 (35g), BP-6EM (15g), MOI-BP (5g), HMOM-TPHAP (6g), Photopolymerization initiator B1 (2g), Photopolymerization initiator C1 (0.05g), DETX-S (0.2g), and IM-1000 (1g) were dissolved in a mixed solvent in which diacetone alcohol/ethyl lactate = 30/70 (mass ratio). The addition amount of the mixed solvent was adjusted in such a manner that the solid concentration was 45 % by mass, using the additives other than the solvent as the solid content. The resulting solution was pressure-filtered using a filter having a retained particle size of 2 μm, thereby obtaining a photosensitive resin composition.

The obtained photosensitive resin composition was applied on a support film (PET film with a thickness of 16 μm and a haze of 0.7% at a wavelength of 405 nm) using a comma roll coater, dried at 75°C for 5 minutes, and then laminated with a 50 μm thick PP film as a protective film to obtain a photosensitive resin sheet having a thickness of 15 μm. The obtained photosensitive resin sheet was used to evaluate the resolution, cracking, depression, surface roughness and film loss, pattern shape, and modulus of elasticity at 180°C by the above-described method. The evaluation results of Example 1 are shown in Table 2 below.

< Examples 2 to 17, Comparative Examples 1 to 3 >

In Examples 2 to 17 of the present invention and Comparative Examples 1 to 3 for the present invention, processing was carried out according to the same method as in Example 1, except that the composition in Example 1 described above was changed to the composition and the thickness of a PET film as the base film, and the haze at a wavelength of 405 nm shown in Tables 2 to 4, thereby producing a photosensitive resin sheet. Using the obtained photosensitive resin sheet, the resolution, cracking, depression, surface roughness and thickness loss, pattern shape, and modulus of elasticity at 180°C were evaluated in accordance with the method described above. The evaluation results of Examples 2 to 17 and Comparative Examples 1 to 3 are shown in Tables 2 to 4.

[Table 2]

| | | Examples | | | | | | | | | |
|---|---|---|---|---|---|---|---|---|---|---|---|
| | | 1 | 2 | 3 | 4 | 5 | 6 | 7 | 8 | 9 | 10 |
| Alkali-soluble polyimide (a) blending amount [g] | Polyimide A1 | 35 | 35 | 35 | 35 | 35 | 35 | 35 | 35 | 35 | 35 |
| Unsaturated bond-containing compound (b) blending amount [g] | BP-6EM | 15 | 15 | 15 | 15 | 15 | 15 | 20 | 15 | 15 | 15 |
| | MOI-BP | 5 | 5 | 5 | 5 | 5 | 5 | - | 5 | 5 | 5 |
| Thermally crosslinkable compound (c) blending amount [g] | HMOM-TPHAP | 6 | 6 | 6 | 6 | 6 | 6 | 6 | 6 | 6 | 6 |
| Photopolymerization initiator (d-1) blending amount [g] | Photopolymerization initiator B 1 | 2 | 2 | 2 | 2 | 2 | - | 2 | 2 | 2 | 2 |
| | Photopolymerization initiator B2 | - | - | - | - | - | 2 | - | - | - | - |
| Photopolymerization initiator (d-2) blending amount [g] | Photopolymerization initiator C1 | 0.05 | 0.1 | 0.5 | 1.0 | 1.2 | 0.5 | 0.5 | 0.5 | 0.5 | 0.5 |
| Other photopolymerization initiator (d') blending amount [g] | IRGACURE OXE01 | - | - | - | - | - | - | - | - | - | - |
| | IRGACURE OXE02 | - | - | - | - | - | - | - | - | - | - |
| | IRGACURE 369 | - | - | - | - | - | - | - | - | - | - |
| Sensitizer (e) blending amount [g] | DETX-S | 0.2 | 0.2 | 0.2 | 0.2 | 0.2 | 0.2 | 0.2 | - | 0.2 | 0.2 |
| Filler (f) blending amount [g] | Glass 1 | - | - | - | - | - | - | - | - | - | - |
| | Sub-silica 1 | - | - | - | - | - | - | - | - | - | - |
| | Nano-silica 1 | - | - | - | - | - | - | - | - | - | - |
| Silane coupling agent blending amount [g] | IM-1000 | 1 | 1 | 1 | 1 | 1 | 1 | 1 | 1 | 1 | 1 |
| Base film | Thickness [μm] | 16 | 16 | 16 | 16 | 16 | 16 | 16 | 16 | 50 | 38 |
| | Haze [%] | 0.7 | 0.7 | 0.7 | 0.7 | 0.7 | 0.7 | 0.7 | 0.7 | 1.3 | 0.5 |
| Resolution | | 4 | 4 | 4 | 3 | 2 | 4 | 4 | 4 | 2 | 4 |
| Cracking | | 3 | 4 | 5 | 5 | 5 | 4 | 4 | 4 | 3 | 4 |
| Depression | | 4 | 4 | 5 | 5 | 5 | 4 | 3 | 4 | 5 | 5 |
| Surface roughness · Thickness loss | | 3 | 3 | 3 | 3 | 3 | 3 | 3 | 3 | 3 | 3 |
| Pattern shape | | 2 | 2 | 2 | 2 | 2 | 2 | 2 | 2 | 2 | 2 |
| Modulus of elasticity at 180°C [GPa] | | 1.7 | 1.7 | 1.7 | 1.7 | 1.7 | 1.7 | 1.7 | 1.7 | 1.7 | 1.7 |

[Table 3]

| | | Examples | | | | | | |
|---|---|---|---|---|---|---|---|---|
| | | 11 | 12 | 13 | 14 | 15 | 16 | 17 |
| Alkali-soluble polyimide (a) blending amount [g] | Polyimide A1 | 35 | 35 | 35 | 35 | 35 | 35 | 35 |
| Unsaturated bond-containing compound (b) blending amount [g] | BP-6EM | 15 | 15 | 15 | 15 | 15 | 15 | 15 |
| | MOI-BP | 5 | 5 | 5 | 5 | 5 | 5 | 5 |
| Thermally crosslinkable compound (c) blending amount [g] | HMOM-TPHAP | 6 | 6 | 6 | 6 | 6 | 6 | 6 |
| Photopolymerization initiator (d-1) blending amount [g] | Photopolymerization initiator B 1 | 2 | - | 2 | 2 | 2 | 2 | 2 |
| | Photopolymerization initiator B2 | - | - | - | - | - | - | - |
| Photopolymerization initiator (d-2) blending amount [g] | Photopolymerization initiator C1 | 0.5 | 0.5 | - | 0.5 | 0.5 | 0.5 | 0.5 |
| Other photopolymerization initiator (d') blending amount [g] | IRGACURE OXE01 | - | 2 | - | - | - | - | - |
| | IRGACURE OXE02 | - | - | 0.5 | - | - | - | - |
| | IRGACURE 369 | - | - | - | - | - | - | - |
| Sensitizer (e) blending amount [g] | DETX-S | 0.2 | 0.2 | 0.2 | 0.2 | 0.2 | 0.2 | 0.2 |
| Filler (f) blending amount [g] | Glass 1 | - | - | - | 27.6 | 96.5 | - | - |
| | Sub-silica 1 | - | - | - | - | - | 27.6 | - |
| | Nano-silica 1 | - | - | - | - | - | - | 27.6 |
| Silane coupling agent blending amount [g] | IM-1000 | 1 | 1 | 1 | 1 | 1 | 1 | 1 |
| Base film | Thickness [μm] | 25 | 16 | 16 | 16 | 16 | 16 | 16 |
| | Haze [%] | 0.6 | 0.7 | 0.7 | 0.7 | 0.7 | 0.7 | 0.7 |
| Resolution | | 4 | 4 | 4 | 4 | 4 | 2 | 3 |
| Cracking | | 5 | 2 | 2 | 5 | 5 | 5 | 5 |
| Depression | | 5 | 2 | 3 | 5 | 5 | 5 | 5 |
| Surface roughness · Thickness loss | | 3 | 2 | 2 | 3 | 3 | 3 | 3 |
| Pattern shape | | 2 | 2 | 2 | 2 | 2 | 2 | 2 |
| Modulus of elasticity at 180°C [GPa] | | 1.7 | 1.7 | 1.7 | 3.7 | 7.7 | 3.7 | 3.7 |

[Table 4]

| | | Comparative Examples | | |
|---|---|---|---|---|
| | | 1 | 2 | 3 |
| Alkali-soluble polyimide (a) blending amount [g] | Polyimide A1 | 35 | 35 | 35 |

(continued)

| | | Comparative Examples | | |
|---|---|---|---|---|
| | | 1 | 2 | 3 |
| Unsaturated bond-containing compound (b) blending amount [g] | BP-6EM | 15 | 15 | 15 |
| | MOI-BP | 5 | 5 | 5 |
| Thermally crosslinkable compound (c) blending amount [g] | HMOM-TPHAP | 6 | 6 | 6 |
| Photopolymerization initiator (d-1) blending amount [g] | Photopolymerization initiator B1 | 2 | - | 2 |
| | Photopolymerization initiator B2 | | | |
| Photopolymerization initiator (d-2) blending amount [g] | Photopolymerization initiator C1 | - | 2 | - |
| Other photopolymerization initiator (d') blending amount [g] | IRGACURE OXE01 | - | - | - |
| | IRGACURE OXE02 | - | - | - |
| | IRGACURE 369 | - | - | 0.5 |
| Sensitizer (e) blending amount [g] | DETX-S | 0.2 | 0.2 | 0.2 |
| Filler (f) blending amount [g] | Glass 1 | - | - | - |
| | Sub-silica 1 | - | - | - |
| | Nano-silica 1 | - | - | - |
| Silane coupling agent blending amount [g] | IM-1000 | 1 | 1 | 1 |
| Base film | Thickness [μm] | 16 | 16 | 16 |
| | Haze [%] | 0.7 | 0.7 | 0.7 |
| Resolution | | 4 | 1 | 4 |
| Cracking | | 1 | 5 | 1 |
| Depression | | 1 | 5 | 1 |
| Surface roughness · Thickness loss | | 2 | 3 | 2 |
| Pattern shape | | 2 | 1 | 2 |
| Modulus of elasticity at 180°C [GPa] | | 1.7 | 1.7 | 1.7 |

As shown in Tables 2 to 3, each evaluation result was favorable in Examples 1 to 17 using two or more types of oxime ester photopolymerization initiators (d).
In Examples 1 to 11 and 14 to 17 using the photopolymerization initiator (d-1) and the photopolymerization initiator (d-2), the evaluation of cracking, depression, and surface roughness and thickness loss was further favorable compared to Examples 12 and 13. On the other hand, as shown in Table 4, Comparative Examples 1 and 3 exhibited inferior results in the evaluation of cracking and depression compared to Examples 1 to 17, and Comparative Example 2 exhibited inferior results in the evaluation of the resolution and the pattern shape compared to Examples 1 to 17.

Industrial Applicability

The photosensitive resin composition of the present invention is a photosensitive resin composition by which a hollow structure lid portion can be patterned by photography with a high sensitivity and a favorable quality. The photosensitive resin sheet of the present invention is suitable for a photosensitive resin sheet that can pattern a hollow structure lid portion by photography with a high sensitivity and a favorable quality. Therefore, the photosensitive resin composition and the photosensitive resin sheet of the present invention are useful for a lid application of a hollow structure of an electronic component having a hollow structure, and specifically, can be suitably used for a lid application of a hollow structure of a surface acoustic wave filter.

DESCRIPTION OF REFERENCE SIGNS

1 Piezoelectric substrate (substrate of piezoelectric material)
2 Convex portion
3 Comb-shaped electrode of surface acoustic wave filter (SAW filter)
4 Support film
5 Photosensitive resin layer
6 Photosensitive resin layer that has been light-cured by exposure

**Claims**

**1.** A photosensitive resin composition comprising an alkali-soluble polyimide (a), an unsaturated bond-containing compound (b), a thermally crosslinkable compound (c), a photopolymerization initiator (d-1) having the structure represented by the following general formula (1) and having a photobleaching property, and a photopolymerization initiator (d-2) having the structure represented by the following general formula (1) and having a molar absorption coefficient at a wavelength of 405 nm of 1,000 L/(mol·cm) or more.

[Chem. 1]

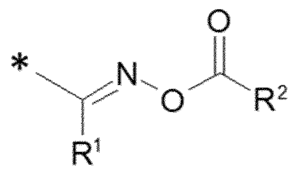
(1)

(In the general formula (1), $R^1$ represents a halogen atom, a hydroxyl group, a carboxyl group, a nitro group, a cyano group, $-NR^3R^4$, a monovalent hydrocarbon group having 1 to 20 carbon atoms, an acyl group having 1 to 20 carbon atoms, or an alkoxy group having 1 to 20 carbon atoms, and $R^3$ and $R^4$ each independently represent a hydrogen atom or an alkyl group having 1 to 10 carbon atoms. Note that at least one of hydrogen atom of the hydrocarbon group, the acyl group, and the alkoxy group may be substituted by halogen atoms, hydroxyl groups, carboxyl groups, nitro groups, cyano groups, or $-NR^3R^4$, and the hydrocarbon groups in the hydrocarbon group, in the acyl group, and in the alkoxy group may be interrupted by an ether bond, a thioether bond, an ester bond, a thioester bond, an amide bond, or a urethane bond. $R^2$ represents an alkyl group having 1 to 5 carbon atoms. In the formula, * means that an adjacent group is bonded at *.)

**2.** A photosensitive resin composition comprising an alkali-soluble polyimide (a), an unsaturated bond-containing compound (b), a thermally crosslinkable compound (c), and two or more types of oxime ester photopolymerization initiators (d).

**3.** The photosensitive resin composition according to claim 2, wherein the oxime ester photopolymerization initiator (d) has the structure represented by the following general formula (2) and comprises at least one or more types of photopolymerization initiators (d-1) having a photobleaching property.

[Chem. 2]

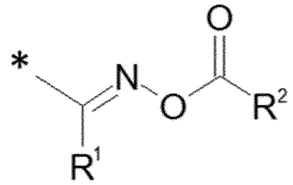
(2)

(In the general formula (2), $R^1$ represents a halogen atom, a hydroxyl group, a carboxyl group, a nitro group, a cyano group, $-NR^3R^4$, a monovalent hydrocarbon group having 1 to 20 carbon atoms, an acyl group having 1 to 20 carbon

atoms, or an alkoxy group having 1 to 20 carbon atoms, and $R^3$ and $R^4$ each independently represent a hydrogen atom or an alkyl group having 1 to 10 carbon atoms. Note that at least one of the hydrogen atoms in the hydrocarbon group, the acyl group, and the alkoxy group may be substituted by a halogen atom, a hydroxyl group, a carboxyl group, a nitro group, a cyano group, or $-NR^3R^4$, and the hydrocarbon groups in the hydrocarbon group, the acyl group, and the alkoxy group may be interrupted by an ether bond, a thioether bond, an ester bond, a thioester bond, an amide bond, or a urethane bond. $R^2$ represents an alkyl group having 1 to 5 carbon atoms. * in the formula means that an adjacent group is bonded at *.)

**4.** The photosensitive resin composition according to claim 2 or 3, wherein the oxime ester photopolymerization initiator (d) comprises at least one type of the photopolymerization initiator (d-2) having a structure represented by the following general formula (3) and a molar absorption coefficient at a wavelength of 405 nm of 1,000 L/(mol·cm) or more.

[Chem. 3]

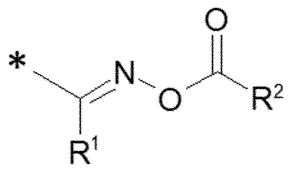

(3)

(In general formula (3), $R^1$ represents a halogen atom, a hydroxyl group, a carboxyl group, a nitro group, a cyano group, $-NR^3R^4$, a monovalent hydrocarbon group having 1 to 20 carbon atoms, an acyl group having 1 to 20 carbon atoms, or an alkoxy group having 1 to 20 carbon atoms, and $R^3$ and $R^4$ each independently represent a hydrogen atom or an alkyl group having 1 to 10 carbon atoms. Note that at least one of the hydrogen atoms in the hydrocarbon group, the acyl group, and the alkoxy group may be substituted by halogen atoms, hydroxyl groups, carboxyl groups, nitro groups, cyano groups, or $-NR^3R^4$, and the hydrocarbon groups in the hydrocarbon group, the acyl group, and the alkoxy group may be interrupted by an ether bond, a thioether bond, an ester bond, a thioester bond, an amide bond, or a urethane bond. $R^2$ represents an alkyl group having 1 to 5 carbon atoms. * in the formula means that an adjacent group is bonded at *).

**5.** The photopolymerization resin composition according to any one of claims 1, 3, and 4, wherein the photopolymerization initiator (d-1) is represented by the following general formula (4).

[Chem. 4]

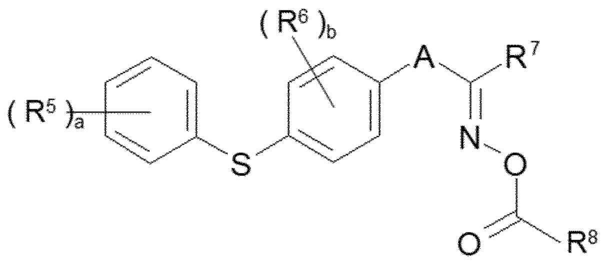

(4)

(In the general formula (4), $R^5$ to $R^7$ each independently represent a halogen atom, a hydroxyl group, a carboxyl group, a nitro group, a cyano group, $-NR^9R^{10}$, a monovalent hydrocarbon group having 1 to 20 carbon atoms, an acyl group having 1 to 20 carbon atoms, or an alkoxy group having 1 to 20 carbon atoms, and $R^9$ and $R^{10}$ each independently represent a hydrogen atom or an alkyl group having 1 to 10 carbon atoms. Note that at least one of the hydrogen atoms in the hydrocarbon group, the acyl group, and the alkoxy group may be substituted by a halogen atom, a hydroxyl group, a carboxyl group, a nitro group, a cyano group, or $-NR^9R^{10}$, and the hydrocarbon groups in the hydrocarbon group, the acyl group, and the alkoxy group may be interrupted by an ether bond, a thioether bond, an ester bond, a thioester bond, an amide bond, or a urethane bond. $R^8$ represents an alkyl group having 1 to 5 carbon atoms. a represents an integer of 0 to 5, and b represents an integer of 0 to 4. A represents CO or a direct bonding)

6. The photosensitive resin composition according to any one of claims 1, 4 to 5, wherein the photopolymerization initiator (d-2) is represented by the following general formula (5).

[Chem. 5]

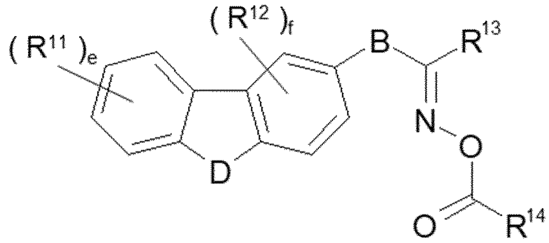

(5)

(In the general formula (5), $R^{11}$ to $R^{13}$ each independently represent a halogen atom, a hydroxyl group, a carboxyl group, a nitro group, a cyano group, $-NR^{15}R^{16}$, a monovalent hydrocarbon group having 1 to 20 carbon atoms, an acyl group having 1 to 20 carbon atoms, or an alkoxy group having 1 to 20 carbon atoms, and $R^{15}$ and $R^{16}$ each independently represent a hydrogen atom or an alkyl group having 1 to 10 carbon atoms. Note that at least one of the hydrogen atoms in the hydrocarbon group, the acyl group, and the alkoxy group may be substituted by halogen atoms, hydroxyl groups, carboxyl groups, nitro groups, cyano groups, or $-NR^{15}R^{16}$, and the hydrocarbon groups in the hydrocarbon group, the acyl group, and the alkoxy group may be interrupted by an ether bond, a thioether bond, an ester bond, a thioester bond, an amide bond, or a urethane bond. $R^{14}$ represents an alkyl group having 1 to 5 carbon atoms. e represents an integer of 0 to 4 and f represents an integer of 0 to 3. B represents CO or a direct bond. D represents $-N(R^{17})-$ or $-C(R^{18})(R^{19})-$. $R^{17}$ to $R^{19}$ each independently represent a hydrogen atom, or a monovalent hydrocarbon group substituent having 1 to 10 carbon atoms.)

7. The photosensitive resin composition according to any one of claims 1, 4 to 6, wherein the content of the photopolymerization initiator (d-2) is 5 to 50 parts by mass based on 100 parts by mass of the total solid content of the photopolymerization initiator (d-1).

8. The photosensitive resin composition according to any one of claims 1 to 7, wherein the alkali-soluble polyimide (a) comprises a phenolic hydroxyl group or a carboxyl group.

9. The photosensitive resin composition according to any one of claims 1 to 8, wherein the unsaturated bond-containing compound (b) comprises an isocyanate group or a blocked isocyanate group.

10. The photosensitive resin composition according to any one of claims 1 to 9, further comprising a sensitizer (e).

11. The photosensitive resin composition according to any one of claims 1 to 10, further comprising a filler (f).

12. The photosensitive resin composition according to claim 11, wherein the filler (f) is glass or a filler having an average particle size of 10 to 100 nm.

13. The photosensitive resin composition according to any one of claims 1 to 12, wherein the modulus of elasticity at 180°C of a cured product of the photosensitive resin composition is 3 GPa or more.

14. The photosensitive resin composition according to any of claims 1 to 13, wherein the thickness of a photosensitive resin after coating and drying on a base material is 12 to 150 μm.

15. A photosensitive resin sheet comprising a support and a photosensitive resin layer formed on the support using the photosensitive resin composition according to any of claims 1 to 14.

16. The photosensitive resin sheet according to claim 15, wherein the haze of the support at a wavelength of 405 nm is 1% or less.

17. The photosensitive resin sheet according to claim 15 or 16, wherein the thickness of the support is 30 μm or less.

18. A hollow structure that is formed by a convex portion provided on a substrate of an electronic component and a lid,

wherein the lid is composed of a photosensitive resin composition layer of the photosensitive resin sheet according to any one of claims 15 to 17.

**19.** An electronic component having the hollow structure according to claim 18.

**20.** The electronic component according to claim 19, wherein the electronic component is a surface acoustic wave filter.

**21.** A method for producing a hollow structure, the method comprising: a layering process (A) in which the photosensitive resin layer is formed by layering a photosensitive resin sheet according to any one of claims 15 to 17 on a convex portion provided to form a hollow structure on a substrate in such a manner to form a lid of the hollow structure; an exposure process (B) in which an exposed portion is photocured by irradiating an active ray to a predetermined portion of the photosensitive resin layer; a baking process (C) in which the exposed portions is promoted curing by heating the photosensitive resin layer; a peeling process (D) in which a support is peeled off; a development process (E) in which a portion of the photosensitive resin layer other than the exposed portion is removed using a developer, if necessary; and a heat curing process (F) in which a resin cured product is formed by heat curing the exposed portion of the photosensitive resin layer.

**22.** The method for producing a hollow structure according to claim 21, wherein, in the exposure process (B), exposure is carried out without peeling off the support from the photosensitive resin sheet.

**23.** The method for producing a hollow structure according to claim 21 or 22, wherein the baking temperature in the baking process (C) is 60 to 180°C.

【Fig. 1】

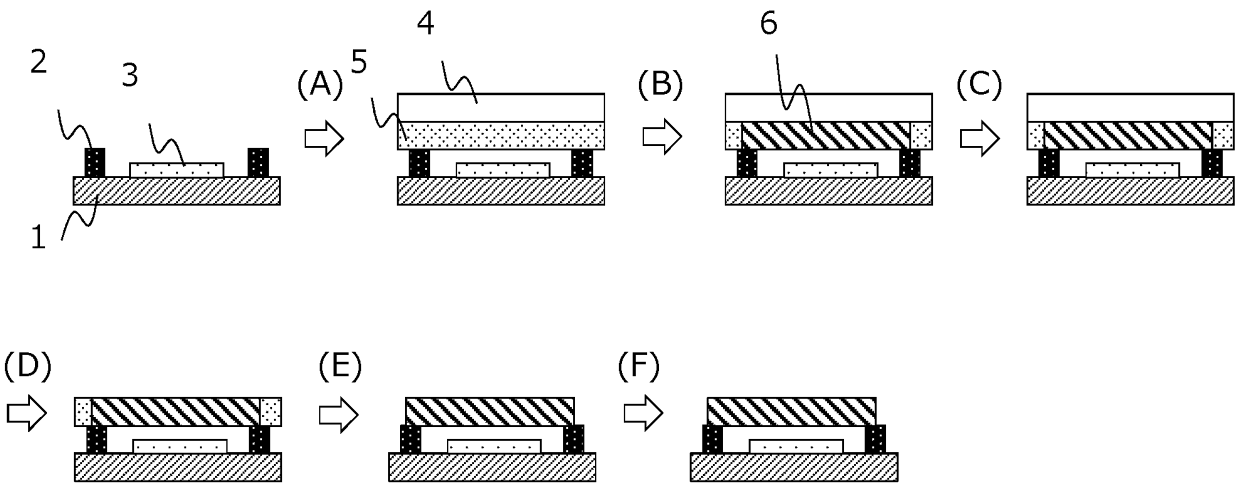

【Fig. 2】

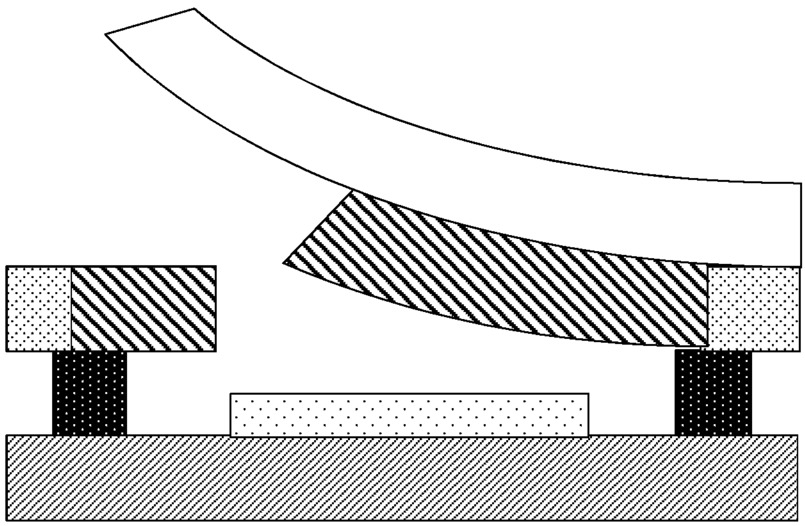

【Fig. 3】

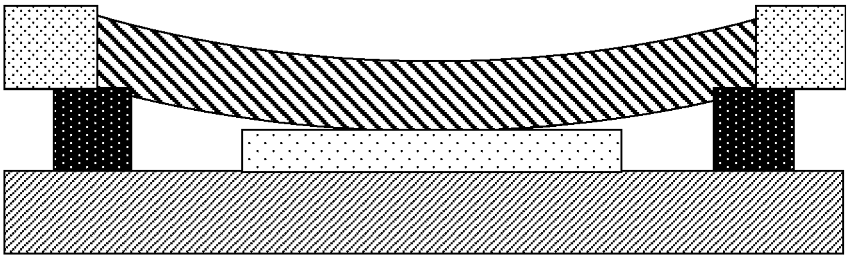

【Fig. 4】

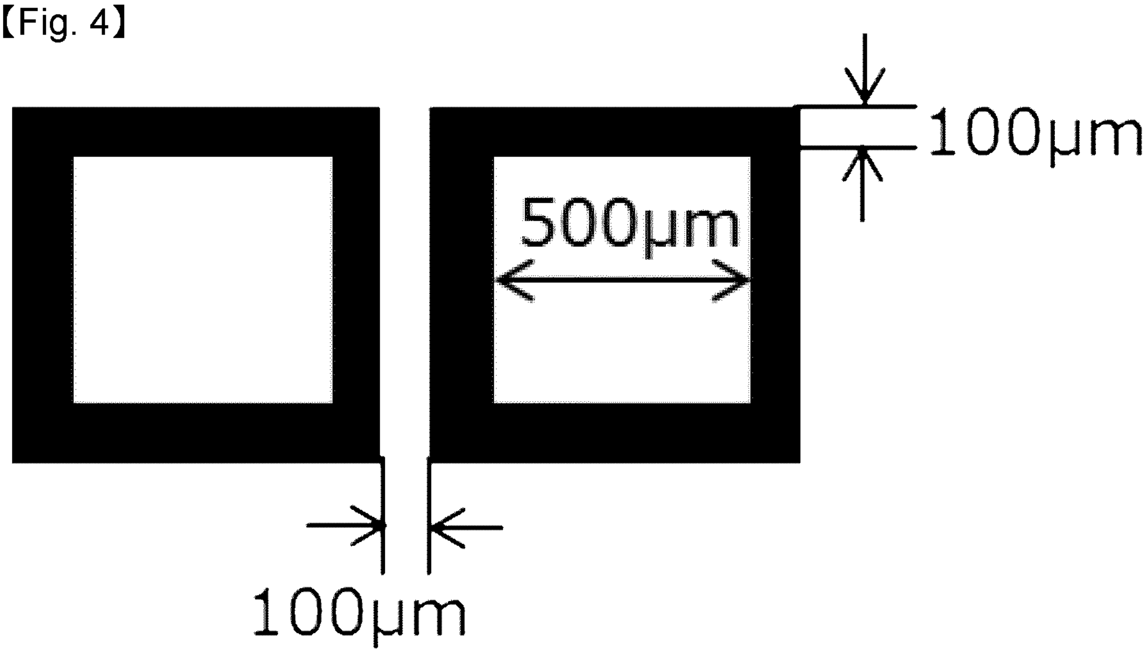

【Fig. 5】

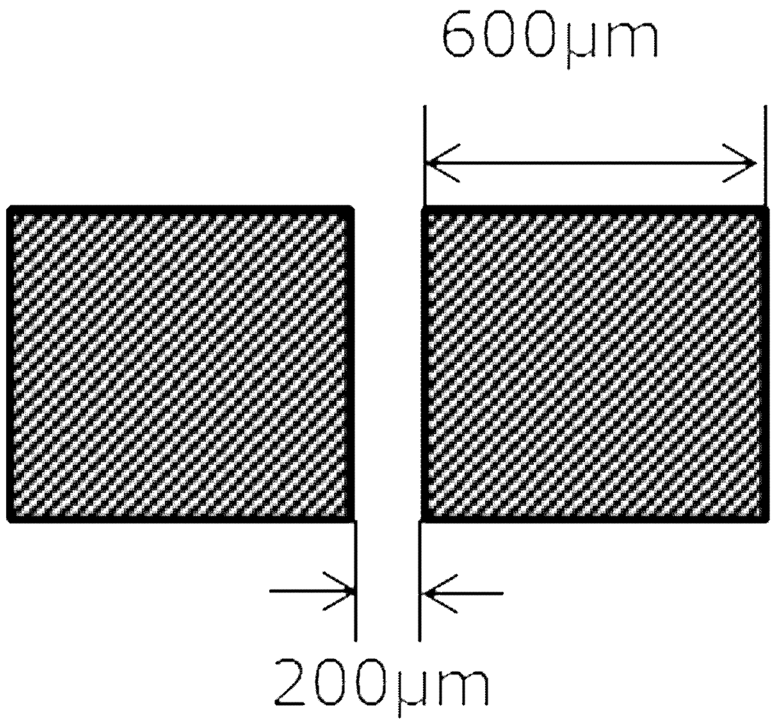

【Fig. 6】

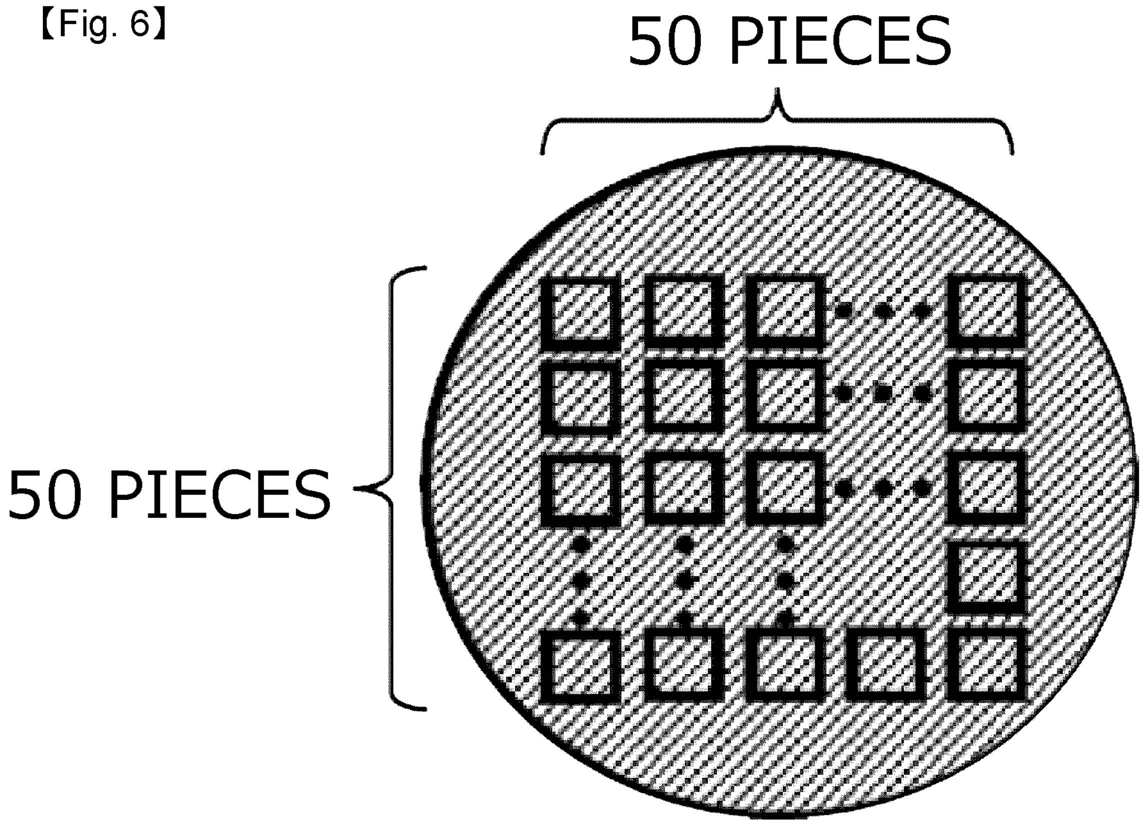

## INTERNATIONAL SEARCH REPORT

International application No. PCT/JP2020/011900

A. CLASSIFICATION OF SUBJECT MATTER
H01L 23/02(2006.01)i; C08F 2/50(2006.01)i; G03F 7/028(2006.01)i; G03F 7/031(2006.01)i; G03F 7/037(2006.01)i; G03F 7/09(2006.01)i; G03F 7/20(2006.01)i; H03H 3/08(2006.01)i
FI: G03F7/031; G03F7/028; G03F7/037; G03F7/09 501; G03F7/20 501; C08F2/50; H01L23/02 J; H03H3/08
According to International Patent Classification (IPC) or to both national classification and IPC

B. FIELDS SEARCHED
Minimum documentation searched (classification system followed by classification symbols)
H01L23/02; C08F2/50; G03F7/028; G03F7/031; G03F7/037; G03F7/09; G03F7/20; H03H3/08

Documentation searched other than minimum documentation to the extent that such documents are included in the fields searched

| | |
|---|---|
| Published examined utility model applications of Japan | 1922-1996 |
| Published unexamined utility model applications of Japan | 1971-2020 |
| Registered utility model specifications of Japan | 1996-2020 |
| Published registered utility model applications of Japan | 1994-2020 |

Electronic data base consulted during the international search (name of data base and, where practicable, search terms used)
CAplus/REGISTRY (STN)

C. DOCUMENTS CONSIDERED TO BE RELEVANT

| Category* | Citation of document, with indication, where appropriate, of the relevant passages | Relevant to claim No. |
|---|---|---|
| X<br>Y<br>A | WO 2018/173840 A1 (TORAY INDUSTRIES, INC.) 27.09.2018 (2018-09-27) claims, examples, paragraphs [0084]-[0086], [0093], [0140] | 2-3, 5, 8, 10-23<br>9<br>1, 4, 6-7 |
| Y | JP 2018-070829 A (TORAY INDUSTRIES, INC.) 10.05.2018 (2018-05-10) paragraph [0048] | 9 |
| A | JP 2017-008219 A (ADEKA CORPORATION) 12.01.2017 (2017-01-12) claims, examples | 1-23 |
| A | WO 2018/052024 A1 (MITSUBISHI CHEMICAL CORPORATION) 22.03.2018 (2018-03-22) claims, examples | 1-23 |
| A | WO 2018/043250 A1 (TORAY INDUSTRIES, INC.) 08.03.2018 (2018-03-08) claims, examples | 1-23 |

☐ Further documents are listed in the continuation of Box C. ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 13 May 2020 (13.05.2020) | 26 May 2020 (26.05.2020) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No.
PCT/JP2020/011900

**Box No. II Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III Observations where unity of invention is lacking (Continuation of item 3 of first sheet)**

This International Searching Authority found multiple inventions in this international application, as follows:
See extra sheet

1. ☐ As all required additional search fees were timely paid by the applicant, this international search report covers all searchable claims.
2. ☒ As all searchable claims could be searched without effort justifying additional fees, this Authority did not invite payment of additional fees.
3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**
☐ The additional search fees were accompanied by the applicant's protest and, where applicable, the payment of a protest fee.
☐ The additional search fees were accompanied by the applicant's protest but the applicable protest fee was not paid within the time limit specified in the invitation.
☐ No protest accompanied the payment of additional search fees.

Form PCT/ISA/210 (continuation of first sheet (2)) (January 2015)

**INTERNATIONAL SEARCH REPORT**
Information on patent family members

International application No.
PCT/JP2020/011900

| Patent Documents referred in the Report | Publication Date | Patent Family | Publication Date |
|---|---|---|---|
| WO 2018/173840 A1 | 27 Sep. 2018 | CN 110419001 A<br>KR 10-2019-0124232 A<br>TW 201841949 A | |
| JP 2018-070829 A | 10 May2018 | (Family: none) | |
| JP 2017-008219 A | 12 Jan. 2017 | (Family: none) | |
| WO 2018/052024 A1 | 22 Mar. 2018 | CN 109791357 A<br>KR 10-2019-0051976 A<br>TW 201818152 A | |
| WO 2018/043250 A1 | 08 Mar. 2018 | TW 201816514 A | |

Form PCT/ISA/210 (patent family annex) (January 2015)

INTERNATIONAL SEARCH REPORT

International application No. PCT/JP2020/011900

<Continuation of Box No. III>

(Invention 1) Claims 1 and 4-23

The invention in claims 1 and 4-23 have the special technical feature of a "photosensitive resin composition containing (a) an alkali-soluble polyimide, (b) an unsaturated bond-containing compound, (c) a thermally crosslinkable compound, (d-1) a photopolymerization initiator which has a structure represented by the following general formula (1) and has photobleaching properties, and (d-2) a photopolymerization initiator which has a structure represented by the following general formula (1) and has a molar extinction coefficient of 1,000 L/(mol·cm) or larger at a wavelength of 405 nm," and thus are classified as invention 1.

(Invention 2) Claims 2-3

Claims 2-3 share the common technical feature of a "photosensitive resin composition containing (a) an alkali-soluble polyimide, (b) an unsaturated bond-containing compound, (c) a thermally crosslinkable compound..." with claim 1 classified as invention 1. However, said technical feature does not make a contribution over the prior art in light of the disclosure of document 1, and thus is not considered to be a special technical feature. In addition, claims 2-3 correspond to the feature of including "at least two kinds of oxime ester-based photopolymerization initiators," but cannot be considered to have the special technical feature classified as invention 1.

Also, claims 2-3 are not dependent on claim 1. In addition, claim 2-3 are not substantially identical or equivalent to any of the claims classified as invention 1.

Thus, claims 2-3 cannot be classified as invention 1.

Document 1: WO 2018/173840 A1 (TORAY INDUSTRIES, INC.) 27.09.2018 (2018-09-27) claims, examples, paragraphs [0084]-[0086], [0093], [0140]

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2010010812 A
- WO 2018173840 A
- WO 2012002028 A
- WO 2015036910 A
- WO 2008078678 A